(19) Europäisches Patentamt
European Patent Office
Office européen des brevets

(11) **EP 3 550 746 A1**

(12) **EUROPEAN PATENT APPLICATION**
published in accordance with Art. 153(4) EPC

(43) Date of publication:
**09.10.2019 Bulletin 2019/41**

(51) Int Cl.:
**H04L 1/00** (2006.01)

(21) Application number: **17883812.4**

(22) Date of filing: **12.12.2017**

(86) International application number:
**PCT/CN2017/115569**

(87) International publication number:
**WO 2018/113550 (28.06.2018 Gazette 2018/26)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: **23.12.2016 CN 201611204798**

(71) Applicant: **Huawei Technologies Co., Ltd.**
**Longgang District**
**Shenzhen, Guangdong 518129 (CN)**

(72) Inventors:
• **LI, Bin**
  **Shenzhen**
  **Guangdong 518129 (CN)**
• **TSE, David**
  **Stanford, California 94305-9515 (US)**
• **SHEN, Hui**
  **Shenzhen**
  **Guangdong 518129 (CN)**

(74) Representative: **Pfenning, Meinig & Partner mbB**
**Patent- und Rechtsanwälte**
**Joachimsthaler Straße 10-12**
**10719 Berlin (DE)**

(54) **CHANNEL ENCODING METHOD, CHANNEL ENCODING APPARATUS, CHIP SYSTEM AND STORAGE MEDIUM**

(57) A channel coding method and a channel coding apparatus are provided. The method includes: separately preprocessing to-be-encoded bit sequences, and then inputting, according to a position arrangement order of encoding sub-blocks of an encoding block in an encoder, bit sequences preprocessed each time into encoding blocks of the encoder. Therefore, preprocessed bit sequences are placed, according to this order, into corresponding encoding blocks each time preprocessing is performed. According to this solution, even if a transmit device does not know exact capacities of the parallel channels, a correct encoding scheme for the transmit device and a correct decoding scheme for a receive device can be designed, and it can be ensured that a combined capacity of the parallel channels can reach 1.

```
┌─────────────────────────────────────────────────────────────┐
│            Preprocess N bit sequences                        │── 101
└─────────────────────────────────────────────────────────────┘
                            │
                            ▼
┌─────────────────────────────────────────────────────────────┐
│ Input, according to a position arrangement order of encoding │
│ sub-blocks of an encoding block in an encoder, N bit          │── 102
│ sequences preprocessed each time into encoding blocks in one  │
│ of M encoders                                                 │
└─────────────────────────────────────────────────────────────┘
                            │
                            ▼
┌─────────────────────────────────────────────────────────────┐
│ Obtain M corresponding encoded sequences after encoding, in   │
│ the encoders, the N preprocessed bit sequences that are input │── 103
└─────────────────────────────────────────────────────────────┘
                            │
                            ▼
┌─────────────────────────────────────────────────────────────┐
│ Respectively send the M obtained encoded sequences on M        │
│ parallel channels through resource mapping                    │── 104
└─────────────────────────────────────────────────────────────┘
```

FIG. 1

EP 3 550 746 A1

## Description

This application claims priority to Chinese Patent Application No. 201611204798.7, filed with the Chinese Patent Office on December 23, 2016 and entitled "CHANNEL CODING METHOD AND CHANNEL CODING APPARATUS", which is incorporated herein by reference in its entirety.

## TECHNICAL FIELD

This application relates to the field of channel coding technologies, and in particular, to a channel coding method, a channel coding apparatus, a chip system, and a storage medium.

## BACKGROUND

In a communications system, a coding technology is usually used to increase a peak value of the communications system and improve reliability of data transmission, and linear precoding needs to be used on a transmit end to adjust amplitude and a phase of a transmit channel. Both a transmit device and a receive device store a precoding matrix codebook. The transmit device may obtain a precoding matrix by factorizing a channel transmission matrix, then encode each piece of data, and send encoded data to corresponding parallel channels for transmission. However, in a precoding method, a specific channel state (including a capacity) of each parallel channel usually needs to be known, and when a capacity of each parallel channel is not known, usually, only diversity (Diversity) technologies can be used. However, all general diversity technologies are used for different modulation symbols in a same encoding block; therefore, no coding gain can be obtained by using the coding technology, and obtained channel capacities of the parallel channels cannot be maximized, in other words, a combined capacity cannot reach 1.

## SUMMARY

This application provides a channel coding method, a channel coding apparatus, a chip system, and a storage medium, so that characteristics of polar (Polar) code can be fully utilized to resolve a prior-art problem that a combined capacity of channels is relatively low when data is sent based on parallel channels. The parallel channels herein are two or more time-domain-based or frequency-domain-based channels, and data is repeatedly sent on the parallel channels after same or different processing (which includes but is not limited to processing such as encoding, modulation, scrambling, and conjugation).

A first aspect provides a channel coding method. Each encoder includes at least N idle encoding blocks that are contiguous in time-domain positions or frequency-domain positions, and encoding blocks in different encoders include a same quantity of encoding sub-blocks. Each encoding block includes P encoding sub-blocks, reliability of the P encoding sub-blocks is sorted in ascending order based on a time-domain ascending order or frequency-domain ascending order, P is a positive integer, and P≥N. The method includes:

first preprocessing N bit sequences, where a manner of the preprocessing mainly includes positive sequencing, reverse sequencing, or linear transformation, or may include another preprocessing manner;

then inputting, according to a position arrangement order of encoding sub-blocks of an encoding block in an encoder, N bit sequences preprocessed each time into encoding sub-blocks of encoding blocks in one of M encoders, where N and M are positive integers, and M≥2; and

obtaining M corresponding encoded sequences after encoding, in the encoders, the N preprocessed bit sequences that are input, and respectively sending the M obtained encoded sequences on M parallel channels through resource mapping, where resource mapping means that for each channel used to transmit an encoded sequence, a to-be-sent encoded sequence is mapped onto a virtual resource block, then the encoded sequence that is mapped onto the virtual resource block is mapped onto a physical resource block, and finally the encoded sequence is sent by using a channel corresponding to the physical resource block.

Compared with that in an existing mechanism, in this application, there is no need to know a capacity of a single parallel channel, before repeated data is input into an encoder, the repeated data is preprocessed first, and then repeated data preprocessed each time is input, according to a position arrangement order of encoding sub-blocks of an encoding block in an encoder, into encoding sub-blocks of encoding blocks in one of the M encoders. In this way, it can be ensured that all bit sequences input into the encoder are input into corresponding encoding sub-blocks according to a rule. Therefore, the N bit sequences can be correctly sent, a preset channel capacity can be reached through a coding gain, and a receive device can correctly decode the N bit sequences.

In some possible designs, different preprocessing may be performed on different bit sequences based on times required for repeated encoding. Inputting the N bit sequences preprocessed each time into the encoding sub-blocks and encoding the input bit sequences mainly includes the following.

a: The N bit sequences are sequentially input, according to a bit order of the bit sequences and a time-domain position ascending order or a frequency-domain position ascending order of encoding blocks in an encoder, into encoding sub-blocks of encoding blocks in a first encoder, and the N bit sequences input into the first encoder are encoded, to obtain a first encoded sequence.

Specifically, an $i^{th}$ bit sequence of the N bit sequences is input, according to the bit order of the bit sequences and the time-domain position ascending order or the frequency-domain position ascending order of encoding blocks in an encoder, into an $i^{th}$ encoding sub-block of an $i^{th}$ encoding block in the first encoder, where i is a positive integer, and $1 \leq i \leq P$.

In addition, at least one of the two following two is further included.

b: The N bit sequences are sequentially input, according to the bit order of the bit sequences and a time-domain position descending order or a frequency-domain position descending order of encoding blocks in an encoder, into encoding sub-blocks of encoding blocks in a second encoder, and the N bit sequences input into the second encoder are encoded, to obtain a second encoded sequence.

Specifically, a $j^{th}$ bit sequence of the N bit sequences is input, according to the bit order of the bit sequences and the time-domain position descending order or the frequency-domain position descending order of encoding blocks in an encoder, into a $j^{th}$ encoding sub-block of a $j^{th}$ encoding block in the first encoder, where j is a positive integer, and $1 \leq j \leq P$.

Alternatively, c: The N bit sequences obtained after linear transformation are input, according to the bit order of the bit sequences and the time-domain position ascending order or the frequency-domain position ascending order of encoding blocks in an encoder, into encoding sub-blocks of encoding blocks in a third encoder, and the N bit sequences input into the third encoder after linear transformation are encoded, to obtain a third encoded sequence.

In case c, linear transformation needs to be performed on the N bit sequences, where linear transformation is performed for (M-2) times, and a quantity of the third encoders is at least one. A specific linear transformation process and a specific process of inputting the N bit sequences into the encoding sub-blocks are as follows:

first performing linear transformation on N bit sequences that are to be input into a $k^{th}$ third encoder, to obtain N new bit sequences, where k is a positive integer, and $1 \leq k \leq N$; and

then inputting an $m^{th}$ new bit sequence of the N new bit sequences into an $m^{th}$ encoding sub-block of an $m^{th}$ encoding block in the $k^{th}$ third encoder, where m is a positive integer, and $1 \leq m \leq P$.

The first encoder, the second encoder, and the third encoder are all polar encoders.

In some possible designs, before the N bit sequences obtained after linear transformation are input into the third encoder, the N new bit sequences may be further mapped onto an X Galois field, where $X = 2^p$, and p is a positive integer. That the N bit sequences are mapped onto the X Galois field includes one of the following:

when $M \leq 4$, the N bit sequences are mapped onto a binary field; or

when M>4, the N bit sequences are mapped onto a q-nary Galois field $2^q$, where q is a positive integer greater than or equal to 2.

After the N bit sequences obtained after linear transformation are input into the third encoder, and before the N bit sequences input into the third encoder after linear transformation are encoded, the N new bit sequences that are mapped onto the X Galois field and that are input into the $j^{th}$ third encoder are mapped onto binary sequences.

In some possible designs, a matrix for linear transformation satisfies:

$$\begin{bmatrix} b_{j,1} & b_{j,2} & \Lambda & b_{j,N} \end{bmatrix} = \begin{bmatrix} a_1 & a_2 & \Lambda & a_N \end{bmatrix} \times \pmb{F}_j \quad , \quad \text{where} \quad b_{j,1} \quad b_{j,2} \quad \Lambda \quad b_{j,N}$$

where $b_{j,1}\ b_{j,2} \wedge b_{j,N}$ represent the N new bit sequences obtained after linear transformation is performed on N bit sequences to be input into a $j^{th}$ third encoder, $a_1\ a_2 \wedge a_N$ represent the N bit sequences to be input into the $j^{th}$ third encoder, and $\pmb{F}_j$ represents the matrix for linear transformation.

In some possible designs, after the N bit sequences are preprocessed, and before the N bit sequences preprocessed each time are input, according to the position arrangement order of encoding sub-blocks of an encoding block in an encoder, into encoding sub-blocks of encoding blocks in one of the M encoders, an encoding sub-block in the first encoder other than an $i^{th}$ encoding sub-block, an encoding sub-block in the second encoder other than a $j^{th}$ encoding sub-block, and an encoding sub-block in the $k^{th}$ third encoder other than an $m^{th}$ encoding sub-block may be further set to zero. An encoding operation process can be simplified in a manner of setting zero.

In this application, the N bit sequences have a same length or different lengths, a length of a first encoding sub-block is the same as that of a second encoding sub-block, the first encoding sub-block is an encoding sub-block in one encoder into which a first bit sequence of the N bit sequences is input after the first bit sequence is preprocessed once, and the second encoding sub-block is an encoding sub-block of another encoder into which the first bit sequence is input after the first bit sequence is preprocessed for another time.

In some possible designs, during encoding of the bit sequences, a coding matrix corresponding to a processing type of preprocessing in an encoder may be invoked based on the processing type, and the N preprocessed bit sequences and the coding matrix are multiplied, to obtain a corresponding encoded sequence. A proper coding matrix is selected, so that an encoded sequence that satisfies a service requirement can be obtained, and an encoded sequence that has a characteristic, for example, an encoded sequence having strong interference resistance or being capable of improving a bit sequence spectrum characteristic or reducing an error, can also be obtained. A specific type of the coding matrix and a quantity of coding matrices are not limited in this application.

A second aspect provides a channel coding method. The method includes:

first preprocessing a first data stream and a second data stream separately, where the first data stream includes $N_1$ bit sequences, the second data stream includes $N_2$ bit sequences, and $N_1$ and $N_2$ are positive integers;

then separately inputting, according to a position arrangement order of encoding sub-blocks of an encoding block in an encoder, bit sequences of a first data stream preprocessed each time and bit sequences of a second data stream preprocessed each time into encoding sub-blocks of different encoding blocks in one of M encoders, where $M \geq 2$, in each encoder, a $(k+1)^{th}$ bit sequence of the first data stream and a $k^{th}$ bit sequence of the second data stream are located in a same encoding block, and k is a positive integer;

in each encoder, encoding a bit sequence that is in an encoding block in which a $k^{th}$ bit sequence of the first data stream is located, so as to obtain a corresponding encoded sequence, where the $k^{th}$ bit sequence of the second data stream is located in an encoding sub-block that has highest reliability in one encoding block; and

finally, respectively sending obtained encoded sequences on M parallel channels through resource mapping, where resource mapping means that for each channel used to transmit an encoded sequence, a to-be-sent encoded sequence is mapped onto a virtual resource block, then the encoded sequence that is mapped onto the virtual resource block is mapped onto a physical resource block, and finally the encoded sequence is sent by using a channel corresponding to the physical resource block.

Encoding blocks in different encoders include a same quantity of encoding sub-blocks. Each encoder includes at least N idle encoding blocks that are contiguous in time-domain positions or frequency-domain positions, where $N=N_1$ or $N=N_2$; and each encoding block includes P encoding sub-blocks, reliability of the P encoding sub-blocks is sorted in ascending order based on a time-domain ascending order or a frequency-domain ascending order, where P is a positive integer, and $P \geq N$.

Compared with that in an existing mechanism, in this application, there is no need to know a capacity of a single parallel channel, before data streams are input into an encoder, bit sequences of the data streams are preprocessed first, and then bit sequences preprocessed each time are input, according to the position arrangement order of encoding sub-blocks of an encoding block in an encoder, into encoding sub-blocks of encoding blocks in one of the M encoders. In this way, it can be ensured that all bit sequences input into the encoder are input into corresponding encoding sub-blocks according to a rule. Therefore, the bit sequences can be correctly sent, a preset channel capacity can be reached through a coding gain, and a receive device can correctly decode the bit sequences.

In some possible designs, different preprocessing may be performed on different bit sequences based on times required for repeated encoding. Inputting the N bit sequences preprocessed each time into the encoding sub-blocks and encoding the input bit sequences mainly includes the following.

a: The N bit sequences are sequentially input, according to a bit order of the bit sequences and a time-domain position ascending order or a frequency-domain position ascending order of encoding blocks in an encoder, into encoding blocks in a first encoder, and the N bit sequences input into the first encoder are encoded, to obtain a first encoded sequence.

Specifically, an $i^{th}$ bit set of the N bit sequences is input, according to the bit order of the bit sequences and the time-domain position ascending order or the frequency-domain position ascending order of encoding blocks in an encoder, into an $i^{th}$ encoding sub-block of an $i^{th}$ encoding block in the first encoder, where i is a positive integer, and $1 \leq i \leq P$. In addition, at least one of the two following two is further included.

b: The N bit sequences are sequentially input, according to the bit order of the bit sequences and a time-domain position descending order or a frequency-domain position descending order of encoding blocks in an encoder, into encoding sub-blocks of encoding blocks in a second encoder, and the N bit sequences input into the second encoder are encoded, to obtain a second encoded sequence.

Specifically, a $j^{th}$ bit set of the N bit sequences is input, according to the bit order of the bit sequences and the time-domain position descending order or the frequency-domain position descending order of encoding blocks in an encoder, into a $j^{th}$ encoding sub-block of a $j^{th}$ encoding block in the second encoder, where j is a positive integer, and $1 \leq j \leq P$.

Alternatively, c: The N bit sequences obtained after linear transformation are input, according to the bit order of the bit sequences and the time-domain position ascending order or the frequency-domain position ascending order of encoding blocks in an encoder, into encoding sub-blocks of encoding blocks in a third encoder, and the N bit sequences input into the third encoder after linear transformation are encoded, to obtain a third encoded sequence.

Specifically, linear transformation is performed on the N bit sequences, where linear transformation may be performed for (M-2) times, and a quantity of the third encoders is at least one. First, linear transformation is performed on the N bit sequences that are to be input into a $k^{th}$ third encoder, to obtain N new bit sequences, where k is a positive integer, and $1 \leq k \leq N$.

Then an $m^{th}$ new bit sequence of the N new bit sequences is input into an $m^{th}$ encoding sub-block of an $m^{th}$ encoding block in the $k^{th}$ third encoder, where m is a positive integer, and $1 \leq m \leq P$.

In some possible designs, before the N bit sequences obtained after linear transformation are input into the encoding sub-blocks of the encoding blocks in the third encoder, the N new bit sequences may be further mapped onto an X Galois field, where $X=2^p$, and p is a positive integer. That the N bit sequences are mapped onto the X Galois field includes one of the following:

when $M \leq 4$, the N bit sequences are mapped onto a binary field; or
when $M > 4$, the N bit sequences are mapped onto a q-nary Galois field $2^q$, where q is a positive integer greater than or equal to 2.

Then, after the N bit sequences obtained after linear transformation are input into the encoding sub-blocks of the encoding blocks in the third encoder, and before the N bit sequences input into the third encoder after linear transformation are encoded, the N new bit sequences that are mapped onto the X Galois field and that are input into the $j^{th}$ third encoder are mapped onto binary sequences.

In some possible designs, a matrix for linear transformation satisfies:

$$\begin{bmatrix} b_{j,1} & b_{j,2} & \Lambda & b_{j,N} \end{bmatrix} = \begin{bmatrix} a_1 & a_2 & \Lambda & a_N \end{bmatrix} \times \boldsymbol{F}_j \quad , \quad \text{where} \quad b_{j,1} \quad b_{j,2} \quad \Lambda \quad b_{j,N}$$

where $b_{j,1}$ $b_{j,2} \wedge b_{j,N}$ represent the N new bit sequences obtained after linear transformation is performed on N bit sequences to be input into a $j^{th}$ third encoder, $a_1$ $a_2 \wedge a_N$ represent the N bit sequences to be input into the $j^{th}$ third encoder, and $\boldsymbol{F}_j$ represents the matrix for linear transformation.

In some possible designs, after the first data stream and the second data stream are preprocessed separately, and before the $i^{th}$ bit set of the N bit sequences is input, according to the bit order of the bit sequence and the time-domain position ascending order of encoding blocks in an encoder, into the $i^{th}$ encoding sub-block of the $i^{th}$ encoding block in the first encoder, an encoding sub-block in the first encoder other than the $i^{th}$ encoding sub-block, an encoding sub-block in the second encoder other than the $j^{th}$ encoding sub-block, and an encoding sub-block in the $k^{th}$ third encoder other than the $m^{th}$ encoding sub-block may be further set to zero. An encoding operation process can be simplified in a manner of setting zero.

In some possible designs, the N bit sequences have a same length or different lengths, a length of a first encoding sub-block is the same as that of a second encoding sub-block, the first encoding sub-block is an encoding sub-block in one encoder into which a first bit sequence of the N bit sequences is input after the first bit sequence is preprocessed once, and the second encoding sub-block is an encoding sub-block of another encoder into which the first bit sequence is input after the first bit sequence is preprocessed for another time.

In some possible designs, a coding matrix corresponding to a processing type of preprocessing in an encoder may be invoked based on the processing type, and the N preprocessed bit sequences and the coding matrix are multiplied, to obtain a corresponding encoded sequence. A proper coding matrix is selected, so that an encoded sequence that satisfies a service requirement can be obtained, and an encoded sequence that has a characteristic, for example, an encoded sequence having strong interference resistance or being capable of improving a bit sequence spectrum characteristic or reducing an error, can also be obtained. A specific type of the coding matrix and a quantity of coding matrices are not limited in this application.

A third aspect of this application provides a channel coding method. In this method, each encoder includes encoding blocks that are contiguous in time-domain positions or frequency-domain positions, and encoding blocks in different encoders include a same quantity of encoding sub-blocks. Each encoding block includes a plurality of encoding sub-blocks, the encoding sub-blocks in the encoding block are corresponding to reliability, and in each encoding block, reliability of encoding sub-blocks is sorted in ascending order based on a time-domain ascending order or frequency-domain ascending order. The method includes:

first preprocessing each bit sequence in a bit sequence set in one of at least two preprocessing manners, where the bit sequence set includes at least two bit sequences, each bit sequence includes N sub-sequences, and N is a positive integer; and optionally, different bit sequences are preprocessed in different manners;

then inputting, according to a position arrangement order of encoding sub-blocks of an encoding block in an encoder, each of N preprocessed sub-sequences into an encoding sub-block of an encoding block in one of M encoders, where a position of an $i^{th}$ encoding sub-block that is of a $(j+i)^{th}$ encoding block and that is corresponding to an $i^{th}$ sub-sequence of a $j^{th}$ bit sequence in the bit sequence set is represented by $Q_{i,(j+i)}$, i<N, i is a nonnegative integer, j and M are positive integers, and bit sequences in at least two encoders are preprocessed in different manners;

encoding a bit sequence that is in the encoding block in which $Q_{i,(j+i)}$ is located, to obtain a corresponding encoded sequence; and

finally, respectively sending, on M parallel channels through resource mapping, encoded sequences obtained after each time of encoding.

Compared with that in an existing mechanism, in this application, there is no need to know a capacity of a single parallel channel, before bit sequences are input into an encoder, the bit sequences are preprocessed first, and then bit sequences preprocessed each time are input, according to the position arrangement order of encoding sub-blocks of an encoding block in an encoder, into encoding sub-blocks of encoding blocks in one of the M encoders. In this way, it can be ensured that all sub-sequences input into the encoder are input into corresponding encoding sub-blocks according to a rule. Therefore, each of the bit sequences can be correctly sent, a preset channel capacity can be reached through a coding gain, and a receive device can correctly decode each bit sequence.

In some possible designs, the encoding a bit sequence that is in the encoding block in which $Q_{i,(j+i)}$ is located includes:

in each encoder, sequentially encoding a bit sequence that is in an encoding block in which an $i^{th}$ sub-sequence of a $j^{th}$ bit sequence is located, a bit sequence that is in an encoding block in which an $i^{th}$ sub-sequence of a $(j+1)^{th}$ bit sequence is located, and a bit sequence that is in an encoding block in which an $i^{th}$ sub-sequence of a $(j+2)^{th}$ bit sequence is located.

In some possible designs, different preprocessing may be performed on different bit sequences based on times required for repeated encoding. Therefore, the inputting, according to a position arrangement order of encoding sub-blocks of an encoding block in an encoder, each of N preprocessed sub-sequences into an encoding sub-block of an encoding block in one of M encoders includes:

sequentially inputting, according to a bit order of bits and a time-domain position ascending order or a frequency-domain position ascending order of encoding blocks in an encoder, all sub-sequences of a same bit sequence into encoding sub-blocks of encoding blocks in a first encoder; and

further includes at least one of the following two items:

sequentially inputting, according to the bit order of the bits and a time-domain position descending order or a frequency-domain position descending order of encoding blocks in an encoder, all sub-sequences of the same bit sequence into encoding sub-blocks of encoding blocks in a second encoder; or

inputting, according to the bit order of the bits and the time-domain position ascending order or the frequency-domain position ascending order of encoding blocks in an encoder, each sub-sequence of the same bit sequence obtained after linear transformation into an encoding sub-block of an encoding block in a third encoder.

In some possible designs, when M≥3, linear transformation is performed for at least once, and a quantity of the third encoders is at least one.

After linear transformation is performed on at least one bit sequence in the bit sequence set, and before the sub-sequences of the same bit sequence obtained after linear transformation are input into the encoding sub-blocks of the encoding blocks in the third encoder, bit sequences obtained after linear transformation may be further mapped onto an X Galois field, where $X=2^p$, and p is a positive integer.

After the sub-sequences of the same bit sequence obtained after linear transformation are input into the encoding blocks in the third encoder, and before the sub-sequences that are of the same bit sequence input into the third encoder after linear transformation are encoded, the bit sequences obtained after linear transformation that are mapped onto the X Galois field and that are input into the third encoder are mapped onto binary sequences.

That the bit sequences obtained after linear transformation are mapped onto the X Galois field includes one of the following:

when M≤4, the bit sequences obtained after linear transformation are mapped onto a binary field; or
when M>4, the bit sequences obtained after linear transformation are mapped onto a q-nary Galois field **2$^q$**, where q is a positive integer greater than or equal to 2.

In some possible designs, a matrix for linear transformation satisfies:

$$\begin{bmatrix} b_{k,1} & b_{k,2} & \Lambda & b_{k,N} \end{bmatrix} = \begin{bmatrix} a_1 & a_2 & \Lambda & a_N \end{bmatrix} \times \boldsymbol{F}_k \quad , \quad \text{where} \quad b_{k,1} \quad b_{k,2} \quad \Lambda \quad b_{k,N}$$

where $b_{k,1}$ $b_{k,2}$ $\wedge$ $b_{k,N}$ represent sub-sequences of a same bit sequence input into a k$^{th}$ third encoder after linear transformation, $a_1$ $a_2$ $\wedge$ $a_N$ separately represent sub-sequences of the same bit sequence that are to be input into the k$^{th}$ third encoder, $\boldsymbol{F}_k$ represents the matrix for linear transformation, N is a quantity of encoding blocks in the encoder, k and N are positive integers, and 1≤k≤N.

In some possible designs, after a first preprocessed bit sequence is input into encoding sub-blocks of encoding blocks in one of the M encoders, and before the bit sequence that is in the encoding block in which $Q_{i,(j+i)}$ is located is encoded, an encoding sub-block, other than the position Qi,(i+i), in the encoder into which the first preprocessed bit sequence is input may be further set to zero.

In some possible designs, sub-sequences of a same bit sequence have a same length or different lengths, a length of a first encoding sub-block is the same as that of a second encoding sub-block, the first encoding sub-block is an encoding sub-block in one encoder into which a first sub-sequence of the bit sequence set is input after the first sub-sequence is preprocessed once, and the second encoding sub-block is an encoding sub-block of another encoder into which the first sub-sequence is input after the first sub-sequence is preprocessed for another time.

In some possible designs, during encoding of the bit sequences, a coding matrix corresponding to a processing type of preprocessing in an encoder may be invoked based on the processing type, and a preprocessed bit sequence set and the coding matrix are multiplied, to obtain a corresponding encoded sequence. A proper coding matrix is selected, so that an encoded sequence that satisfies a service requirement can be obtained, and an encoded sequence that has a characteristic, for example, an encoded sequence having strong interference resistance or being capable of improving a bit sequence spectrum characteristic or reducing an error, can also be obtained. A specific type of the coding matrix and a quantity of coding matrices are not limited in this application.

A fourth aspect of this application provides a channel coding apparatus, implementing a function corresponding to the channel coding method provided in the first aspect. The function may be implemented by hardware, or may be implemented by hardware executing corresponding software. The hardware or software includes one or more modules corresponding to the foregoing function. The modules may be hardware and/or software.

In a possible design, the apparatus includes:

a processing module, configured to preprocess N bit sequences, and input, according to a position arrangement order of encoding sub-blocks of an encoding block in an encoder, N bit sequences preprocessed each time into encoding sub-blocks of encoding blocks in one of M encoders, where N and M are positive integers, and M≥2;
encoders, configured to encode the N preprocessed bit sequences input into the encoders, to obtain M corresponding encoded sequences; and
a transceiver module, configured to respectively send, on M parallel channels, the M encoded sequences obtained through encoding.

In a possible design, the channel coding apparatus includes:

at least one processor, a memory, an encoder, and a transceiver, where
the memory is configured to store program code, and the processor is configured to invoke the program code stored in the memory, to perform the following operations:

preprocessing N bit sequences, and inputting, according to a position arrangement order of encoding sub-blocks of an encoding block in an encoder, N bit sequences preprocessed each time into encoding sub-blocks of encoding blocks in one of M encoders, where N and M are positive integers, and M≥2;
encoding the N preprocessed bit sequences input into the encoders, to obtain M corresponding encoded sequences; and
respectively sending, on M parallel channels by using the transceiver, the M encoded sequences obtained through encoding.

The transceiver may alternatively be replaced with a receiver and a transmitter, and the receiver and the transmitter may be a same physical entity or different physical entities. When being the same physical entity, the receiver and the transmitter may be collectively referred to as a transceiver. The memory may be integrated into the processor, or may be separate from the processor.

A fifth aspect of this application provides a channel coding apparatus, implementing a function corresponding to the channel coding method provided in the second aspect. The function may be implemented by hardware, or may be implemented by hardware executing corresponding software. The hardware or software includes one or more modules corresponding to the foregoing function. The modules may be hardware and/or software.

In a possible design, the apparatus includes:

a processing module, configured to: preprocess a first data stream and a second data stream separately, where the first data stream includes $N_1$ bit sequences, the second data stream includes $N_2$ bit sequences, and $N_1$ and $N_2$ are positive integers; and separately input, according to a position arrangement order of encoding sub-blocks of an encoding block in an encoder, bit sequences of a first data stream preprocessed each time and bit sequences of a second data stream preprocessed each time into encoding sub-blocks of different encoding blocks in one of M encoders, where $M \geq 2$, a $(k+1)^{th}$ bit sequence of the first data stream and a $k^{th}$ bit sequence of the second data stream are located in a same encoding block, and k is a positive integer;

an encoder, configured to encode a bit sequence that is in an encoding block in which a $k^{th}$ bit sequence of the first data stream input into the encoder is located, so as to obtain a corresponding encoded sequence, where the $k^{th}$ bit sequence of the second data stream is located in an encoding sub-block that has highest reliability in one encoding block; and

a transceiver module, configured to respectively send, on M parallel channels, encoded sequences obtained through encoding.

In a possible design, the apparatus includes:

at least one processor, a memory, and a transceiver, where
the memory is configured to store program code, and the processor is configured to invoke the program code stored in the memory, to perform the following operations:

preprocessing a first data stream and a second data stream separately, where the first data stream includes $N_1$ bit sequences, the second data stream includes $N_2$ bit sequences, and $N_1$ and $N_2$ are positive integers; and separately inputting, according to a position arrangement order of encoding sub-blocks of an encoding block in an encoder, bit sequences of a first data stream preprocessed each time and bit sequences of a second data stream preprocessed each time into encoding sub-blocks of different encoding blocks in one of M encoders, where $M \geq 2$, a $(k+1)^{th}$ bit sequence of the first data stream and a $k^{th}$ bit sequence of the second data stream are located in a same encoding block, and k is a positive integer;

encoding a bit sequence that is in an encoding block in which a $k^{th}$ bit sequence of the first data stream input into the encoder is located, so as to obtain a corresponding encoded sequence, where the $k^{th}$ bit sequence of the second data stream is located in an encoding sub-block that has highest reliability in one encoding block; and respectively sending, on M parallel channels by using the transceiver, the encoded sequences obtained through encoding.

The transceiver may alternatively be replaced with a receiver and a transmitter, and the receiver and the transmitter may be a same physical entity or different physical entities. When being the same physical entity, the receiver and the transmitter may be collectively referred to as a transceiver. The memory may be integrated into the processor, or may be separate from the processor.

A sixth aspect of this application provides a channel coding apparatus, implementing a function corresponding to the channel coding method provided in the third aspect. The function may be implemented by hardware, or may be implemented by hardware executing corresponding software. The hardware or software includes one or more modules corresponding to the foregoing function. The modules may be hardware and/or software.

In a possible design, the apparatus includes:

a processing module, configured to: preprocess each bit sequence in a bit sequence set in one of at least two preprocessing manners, where the bit sequence set includes at least two bit sequences, each bit sequence includes N sub-sequences, and N is a positive integer; and input, according to a position arrangement order of encoding sub-blocks of an encoding block in an encoder, each of N preprocessed sub-sequences into an encoding sub-block of an encoding block in one of M encoders, where a position of an $i^{th}$ encoding sub-block that is of a $(j+i)^{th}$ encoding block and that is corresponding to an $i^{th}$ sub-sequence of a $j^{th}$ bit sequence in the bit sequence set is represented by $Q_{i,(j+i)}$, i<N, i is a nonnegative integer, j and M are positive integers, and bit sequences in at least two encoders are preprocessed in different manners;

an encoder, configured to encode a bit sequence that is in the encoding block in which $Q_{i,(j+i)}$ is located, to obtain a corresponding encoded sequence; and

a transceiver module, configured to respectively send, on M parallel channels, encoded sequences obtained after each time of encoding.

In a possible design, the apparatus includes at least one processor, a memory, and a transceiver. the memory is configured to store program code, and the processor is configured to invoke the program code stored in the memory, to perform the following operations:

preprocessing each bit sequence in a bit sequence set in one of at least two preprocessing manners, where the bit sequence set includes at least two bit sequences, each bit sequence includes N sub-sequences, and N is a positive integer; and inputting, according to a position arrangement order of encoding sub-blocks of an encoding block in an encoder, each of N preprocessed sub-sequences into an encoding sub-block of an encoding block in one of M encoders, where a position of an $i^{th}$ encoding sub-block that is of a $(j+i)^{th}$ encoding block and that is corresponding to an $i^{th}$ sub-sequence of a $j^{th}$ bit sequence in the bit sequence set is represented by $Q_{i,(j+i)}$, i<N, i is a nonnegative integer, j and M are positive integers, and bit sequences in at least two encoders are preprocessed in different manners;

encoding a bit sequence that is in the encoding block in which $Q_{i,(j+i)}$ is located, to obtain a corresponding encoded sequence; and

respectively sending, on M parallel channels by using the transceiver, the encoded sequences obtained after each time of encoding.

In a possible design, the channel coding apparatus may include one or more processors, one or more encoders, and a communications unit. The one or more processors are configured to support the communications device in executing corresponding functions in the foregoing method. The communications unit is configured to support communication between the channel coding apparatus and another device, to implement a transmit/receive function.

Optionally, the communications device may further include one or more memories. The memory is configured to be coupled with the processor and stores a program instruction and data that are necessary for the channel coding apparatus. The one or more memories may be integrated with the processor, or may be separate from the processor. This is not limited in this application.

The channel coding apparatus may be further a communications chip, may be disposed in a terminal device or a communications device on a network side. The communications unit may be an input/output circuit or interface of the communications chip.

Another aspect of this application provides a computer readable storage medium including an instruction, where when the instruction runs on a computer, the computer is caused to perform the methods in the foregoing aspects.

Compared with that in the prior art, in the solution provided in embodiments of this application, a transmit device does not need to know a capacity of a single parallel channel, and before inputting bit sequences into an encoder, the transmit device first preprocesses the bit sequences, and then inputs, according to the position arrangement order of encoding sub-blocks of an encoding block in an encoder, bit sequences preprocessed each time into encoding sub-blocks of encoding blocks in one of the M encoders. In this way, it can be ensured that all bit sequences input into the encoder are input into corresponding encoding sub-blocks according to a rule. Therefore, the bit sequences can be correctly sent, a preset channel capacity can be reached through a coding gain, and a receive device can correctly decode the bit sequences.

## BRIEF DESCRIPTION OF DRAWINGS

FIG. 1 is a schematic flowchart of a channel coding method according to an embodiment;
FIG. 2-1 is a schematic structural diagram of an encoding block in an encoder according to an embodiment;
FIG. 2-2 is another schematic structural diagram of an encoding block in an encoder according to an embodiment;

FIG. 3 is a schematic diagram of position distribution of a bit sequence that is input into an encoder according to an embodiment;

FIG. 4 is another schematic diagram of position distribution of a bit sequence that is input into an encoder according to an embodiment;

FIG. 5 is another schematic diagram of position distribution of a bit sequence that is input into an encoder according to an embodiment;

FIG. 6 is another schematic flowchart of a channel coding method according to an embodiment;

FIG. 7 is another schematic diagram of position distribution of a bit sequence that is input into an encoder according to an embodiment;

FIG. 8 is another schematic diagram of position distribution of a bit sequence that is input into an encoder according to an embodiment;

FIG. 9 is another schematic flowchart of a channel coding method according to an embodiment;

FIG. 10 is a schematic structural diagram of a channel coding apparatus according to an embodiment;

FIG. 11 is another schematic structural diagram of a channel coding apparatus according to an embodiment; and

FIG. 12 is a schematic structural diagram of an entity apparatus configured to perform a channel coding method according to an embodiment.

## DESCRIPTION OF EMBODIMENTS

In the specification, claims, and accompanying drawings of this application, terms "first", "second", and so on are intended to distinguish between similar objects but do not necessarily indicate a specific order or sequence. It should be understood that data termed in such a way is interchangeable in proper circumstances so that the embodiments described herein can be implemented in other orders than the order illustrated or described herein. In addition, terms "include", "have", or any other variant thereof are intended to cover a non-exclusive inclusion. For example, a process, a method, a system, a product, or a device that includes a series of steps or modules is not necessarily limited to the steps or modules that are expressly listed, but may include another step or module not expressly listed or inherent to the process, the method, the product, or the device. The module division in the embodiments of this application is merely logical division, and there may be another division during implementation in actual application. For example, a plurality of modules may be combined or integrated into another system, or some features may be ignored or not performed. In addition, the displayed or discussed mutual couplings or direct couplings or communication connections may be implemented through some interfaces. The indirect couplings or communication connections between the modules may be implemented in electrical or another form, and this is not limited in the embodiments of this application. In addition, modules or sub-modules described as separate components may be or may not be physically separated, or may be or may not be physical modules, or may be distributed in a plurality of circuit modules. Objectives of the solutions of the embodiments of this application may be achieved by selecting some or all of the modules according to actual requirements.

A channel coding method, a channel coding apparatus, a chip system, and a storage medium are provided in the embodiments of this application and are applied to a Global System for Mobile Communications (English full name: Global System of Mobile communication, GSM for short) system, a general packet radio service (English full name: General Packet Radio Service, GPRS for short) system, a Code Division Multiple Access (English full name: Code Division Multiple Access, CDMA for short) system, a Wideband Code Division Multiple Access (English full name: Wideband Code Division Multiple Access Wireless, WCDMA for short) system, a Long Term Evolution (English full name: Long Term Evolution, LTE for short) system, and various types of subsequently evolved wireless communications systems that include but are not limited to a communications system such as a fifth generation (English full name: 5th Generation, 5G for short) mobile communications system.

A transmit device may be a network device or a terminal device, and a receive device may be a terminal device or a network device. The network device includes but is not limited to an evolved NodeB (English full name: evolved Node Base, eNB for short), a radio network controller (English full name: Radio Network Controller, RNC for short), a NodeB (English full name: NodeB, NB for short), a base station controller (English full name: Base Station Controller, BSC for short), a base transceiver station (English full name: Base Transceiver Station, BTS for short), a home evolved NodeB or home NodeB (for example, a Home evolved NodeB or Home NodeB, HNB for short), and a baseband unit (English full name: Baseband Unit, BBU for short).

The terminal device in the embodiments of this application may be a device that provides voice and/or data connectivity for a user, a handheld device with a wireless connection function, or another processing device connected to a wireless modem. The terminal device may communicate with one or more core networks through a radio access network (English full name: Radio Access Network, RAN for short). The terminal device may be a mobile terminal, such as a mobile phone (or referred to as a "cellular" phone) or a computer with a mobile terminal, for example, may be a portable, a pocket-sized, a handheld, a computer built-in, or an in-vehicle mobile apparatus, which exchanges voice and/or data with the radio access network. For example, the terminal device is a device, such as a personal communication service (English full name: Personal Communication Service, PCS for short) phone, a cordless phone, a Session Initiation Protocol (SIP) phone set, a wireless local loop (Wireless Local Loop, WLL for short) station, or a personal digital assistant (English full name: Personal Digital Assistant, PDA for short). A wireless terminal may also be referred to as a system, a subscriber unit (Subscriber Unit), a subscriber station (Subscriber Station), a mobile station (Mobile Station), a mobile station (Mobile), a remote station (Remote Station), an access point (Access Point), a remote terminal (Remote Terminal), an access terminal (Access Terminal), a user terminal (User Terminal), a terminal device, a user agent (User Agent), a user device (User Device), or user equipment (User Equipment).

The channel coding apparatus in this application includes a plurality of encoders, and each encoder is corresponding to one parallel channel. The parallel channels herein are two or more time-domain-based or frequency-domain-based channels, and data is repeatedly sent on the parallel channels after same or different processing (which includes but is not limited to processing such as encoding, modulation, scrambling, and conjugation). Each encoder includes a plurality of encoding blocks, the encoding blocks may be sequenced in time-domain ascending order or frequency-domain ascending order, and encoding blocks of different encoders include a same quantity of encoding sub-blocks. Each encoding block includes a plurality of encoding sub-blocks. In each encoding block, an encoding sub-block, a length of the encoding sub-block, and reliability of the encoding sub-block are in one-to-one correspondence, and a position of an encoding sub-block in an encoding block represents reliability of the encoding sub-block. In an encoding block, encoding sub-blocks are sequenced in ascending order according to reliability. The encoder used in this application may be a polar encoder or may be another type of encoder. A specific type is not limited in this application.

In actual application, a channel can be ultimately polarized through polarization by using a polar encoder, to obtain an almost noiseless channel and a pure noise channel. Then, even if a channel state is not known in advance, in other words, even if which channel is a noiseless channel and which channel is a pure noise channel are not known, it can be ensured that data is correctly transmitted through the almost noiseless channel. It can be learned that a characteristic that bit positions in the polar encoder are sequenced according to reliability can be fully utilized by using the polar encoder, so as to transform all input bit sequences into low bit rate encoded sequences, and achieve a capacity of the parallel channels. Data transmitted through the almost noiseless channel includes but is not limited to payload (payload), a packet, and control data.

Reliability of an encoding sub-block is reliability of encoding, for example, may be a sequence number of a channel with highest reliability. A length of an encoding sub-block is a maximum quantity of bits that can be accommodated in the encoding sub-block, or may be referred to as a bit capacity.

Before a bit sequence is sent to a defined channel for transmission, the to-be-encoded bit sequence needs to be input into the channel coding apparatus, and the input bit sequence is encoded. Then, an encoded bit sequence is sent to the channel for transmission. In this application, encoding performed on the bit sequence is repeated encoding, and sending the encoded bit sequence to the channel for transmission is transmission based on parallel channels. The parallel channels in this application may be polar channels, reliability of channels that participate in transmitting repeated bit sequences may be the same, or may be in descending order. This is not specifically limited in this application. Each bit sequence sent to the channel may be referred to as one piece of repeated data, or referred to as repeated information bits, or the like.

To resolve the foregoing technical problem, the embodiments of this application mainly provide the following technical solutions:

On a transmit device side, to-be-coded bit sequences are preprocessed first, and then bit sequences preprocessed each time are input, according to a position arrangement order of encoding sub-blocks of an encoding block in an encoder, into encoding blocks of the encoder. Therefore, preprocessed bit sequences are placed, according to this order, into corresponding encoding blocks each time preprocessing is performed. In this way, after bit sequences of a same data stream are transmitted by using parallel channels, a receive device receives the repeated bit sequences sent from a transmit device, decodes a bit sequence from each channel, and then can calculate, based on decoding results, a correct order of bits in the bit sequences. The receive device may use a manner such as successive cancellation (Successive Cancellation for short, English full name: SC) decoding, belief propagation (English full name: Belief Propagation, BP for short) decoding, or list decoding. A specific decoding manner is not limited in this application.

It can be learned that, according to this solution, even if the transmit device does not know exact capacities of the parallel channels, a correct encoding scheme for the transmit device and a correct decoding scheme for the receive device can be designed, and it can be ensured that a combined capacity of the parallel channels can reach 1.

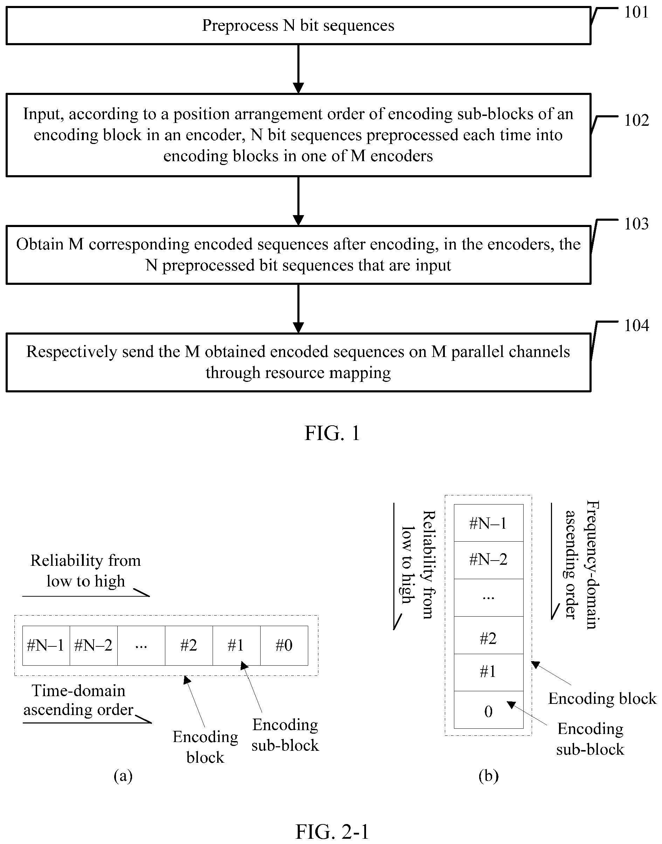

In FIG. 1, a channel coding method provided in this application is described by using an example from a perspective of encoding bit sequences of a same data stream. Before data streams are input into an encoder, one data stream is first divided into N bit sequences based on an encoding requirement. Each bit sequence includes at least one bit, and for different data streams, a value of N may vary based on a current encoding requirement. Neither quantities of bit sequences obtained by dividing different data streams nor a quantity of bit sequences obtained by dividing one data stream is limited in this application. If the N bit sequences need to be transmitted on M channels after being encoded, M encoders that are capable of encoding the N bit sequences need to be selected first. Each encoder includes at least N encoding blocks, each encoding block may include at least N encoding sub-blocks (for example, includes P encoding sub-blocks), reliability of the P encoding sub-blocks is sorted in ascending order based on a time-domain ascending order or frequency-domain ascending order, P is a positive integer, and P≥N. FIG. 2-1 is a schematic diagram of a reliability order of encoding sub-blocks in one encoding block. In FIG. 2-1, in (a) and (b), each block represents one encoding sub-block, and a reference number in the block represents an encoding sub-block index of the encoding sub-block, for example, #1 represents an index of an encoding sub-block in which a bit sequence is located. An encoding sub-block whose index is 1 has highest reliability, and an encoding sub-block whose index is N has lowest reliability.

Encoding blocks in different encoders have a same quantity of encoding sub-blocks, the N bit sequences have a same length or different lengths, a length of a first encoding sub-block is the same as that of a second encoding sub-block, the first encoding sub-block is an encoding sub-block in one encoder into which a first bit sequence of the N bit sequences is input after the first bit sequence is preprocessed once, and the second encoding sub-block is an encoding sub-block of another encoder into which the first bit sequence is input after the first bit sequence is preprocessed for another time. The following describes an embodiment of this application, and this embodiment of this application includes the following steps.

101. Preprocess N bit sequences.

N bit sequences preprocessed each time may be used as one piece of repeated data. The following three sequence transformation preprocessing manners are mainly used for the N bit sequences: positive sequencing, reverse sequencing, and linear transformation. Certainly, another preprocessing manner may also be used, such as reversible non-linear transformation or bit-reverse sequencing. A specific preprocessing manner is not limited in this application.

Positive sequencing means that N to-be-preprocessed bit sequences are sequenced according to a bit order of the bit sequences. For example, when one data stream is divided into bit sequences $a_0$, $a_1$, and $a_2$ (that is, when N=3), $a_0$, $a_1$, and $a_2$ may include a same quantity of bits or different quantities of bits, and a specific quantity of bits may depend on a bit capacity of an encoding sub-block into which a bit sequence actually needs to be input. A bit order of $a_0$, $a_1$, and $a_2$ is a descending order. When being input into encoding blocks, $a_0$, $a_1$, and $a_2$ may be input into corresponding encoding blocks according to the bit order of $a_0$, $a_1$, and $a_2$.

Reverse sequencing means that N to-be-preprocessed bit sequences are sequenced according to a reverse bit order of the bit sequences.

It should be noted that if another input rule is set for positive sequencing and reverse sequencing, to some extent, it can also be regarded that the N original bit sequences are not preprocessed. For example, one data stream is divided into bit sequences $a_0$, $a_1$, and $a_2$, $a_0$, $a_1$, and $a_2$ may include a same quantity of bits or different quantities of bits, and a specific quantity of bits may depend on a bit capacity of an encoding sub-block into which a bit sequence actually needs to be input. A bit order of $a_0$, $a_1$, and $a_2$ is a descending order. When being input into encoding blocks, $a_0$, $a_1$, and $a_2$ may be input into corresponding encoding blocks according to the bit order of $a_0$, $a_1$, and $a_2$; or $a_0$, $a_1$, and $a_2$ may be input into corresponding encoding blocks according to a bit order of $a_2$, $a_1$, and $a_0$. Note that bits included in each of $a_2$, $a_1$, and $a_0$ may be in reverse order or may not be in reverse order in this reverse sequencing. Herein, a bit order is represented by a bit order of $a_2$, $a_1$, and $a_0$, without specific division. Same processing is applied to the following description. Therefore, actually, it can also be regarded that the three bit sequences $a_0$, $a_1$, and $a_2$ are not preprocessed. Reverse processing is used as an example in all the following content in this application. In addition, reverse sequencing does not necessarily indicate that original bit order is reversed, and it only needs to ensure that bits of a plurality of bit sequences in N transformed bit sequences are different from those before transformation.

Linear transformation means mapping from one linear space onto another linear space in a same domain. In this application, original bit sequences may be transformed to bit sequences in another linear space by performing linear transformation on the bit sequences. During linear transformation, vectors of the transformed bit sequences may be obtained by multiplying vectors of the original bit sequences and a coding matrix. A matrix for linear transformation may satisfy:

$$\begin{bmatrix} b_{j,1} & b_{j,2} & \Lambda & b_{j,N} \end{bmatrix} = \begin{bmatrix} a_1 & a_2 & \Lambda & a_N \end{bmatrix} \times \boldsymbol{F}_j \quad , \quad \text{where} \quad b_{j,1} \quad b_{j,2} \quad \Lambda \quad b_{j,N}$$

where $b_{j,1}\ b_{j,2} \wedge b_{j,N}$ represent the N new bit sequences obtained after linear transformation is performed on N bit sequences to be input into a jth third encoder, $a_1\ a_2 \wedge a_N$ represent the N bit sequences to be input into the jth third encoder, and $\boldsymbol{F}_j$ represents the matrix for linear transformation. Transformation may be further performed based on the formula used in this application, to obtain another formula of linear transformation. A specific formula of linear transformation is not limited in this application.

102. Input, according to a position arrangement order of encoding sub-blocks of an encoding block in an encoder, N bit sequences preprocessed each time into encoding blocks in one of M encoders.

N and M are positive integers, M≥2, and after each time of preprocessing, the N bit sequences are input into a different encoder.

103. Obtain M corresponding encoded sequences after encoding, in the encoders, N preprocessed bit sequences that are input.

During encoding, a coding matrix corresponding to a processing type of preprocessing in an encoder may be invoked based on the processing type, and the N preprocessed bit sequences and the coding matrix are multiplied, to obtain a corresponding encoded sequence.

It is assumed that three parallel channels are required in total, and correspondingly, three coding matrices in the encoders are A, B, and C. The following sequences may be obtained by multiplying each of the three coding matrices and N input bit sequences $(a_0, a_1, a_2, ..., a_{N-1})$:

$$(x_0, x_1, x_2, \ldots, x_{N-1}) = (a_0, a_1, a_2, \ldots, a_{N-1}) \times A; \qquad (1)$$

$$(y_0, y_1, y_2, \ldots, y_{N-1}) = (a_0, a_1, a_2, \ldots, a_{N-1}) \times B; \qquad (2)$$

$$(z_0, z_1, z_2, \ldots, z_{N-1}) = (a_0, a_1, a_2, \ldots, a_{N-1}) \times C; \qquad (3)$$

For any $k1 \geq 0$, $k2 \geq 0$, and $k3 \geq 0$, k1, k2, and k3 are all integers, and $k1+k2+k3=N-1$.

On a receive device end, received bit sequences are decoded by using a general decoding matrix based on a predefined encoding/decoding codebook. If first k1 x are known, $(x_0, x_1, x_2, ..., x_{k1})$ is known, if first k2 y are obtained through decoding, $(y_0, y_1, y_2, ..., y_{k2})$ can be calculated, if first k3 z are obtained through decoding, $(z_0, z_1, z_2, ..., z_{k3})$ can be calculated, and so on. Finally, the receive end can obtain $(a_0, a_1, a_2, ..., a_{N-1})$ through decoding.

In addition, a coding matrix affects a channel capacity size, and therefore affects system performance of a communications system. Therefore, weight parameters of coding matrices may be further designed to select an appropriate coding matrix to encode the bit sequences.

Repeated data in this application is transmitted based on repeated encoding and parallel channels; therefore, for different channels, preprocessing may be the same or different. In step 103, that the N bit sequences preprocessed in step 101 are input into corresponding encoding blocks and are encoded may occur in the two following scenarios:

1. M=2 scenario

Two times of different preprocessing need to be performed on the N bit sequences. The N bit sequences preprocessed each time are input into one encoder. After each time of preprocessing, the N bit sequences are input into a different encoder. The two following cases are mainly included:

    a. After one time of positive sequencing, the N bit sequences are input into one encoder; and after one time of linear transformation, the N bit sequences are input into another encoder.
    b. After one time of positive sequencing, the N bit sequences are input into one encoder; and after one time of reverse sequencing, the N bit sequences are input into another encoder.

2. M≥3 scenario

Preprocessing including one time of positive sequencing, one time of reverse sequencing, and (M-2) times of linear transformation needs to be performed on the N bit sequences. A same formula or different formulas may be used in preprocessing of the (M-2) times of linear transformation. A specific formula used in the (M-2) times of linear transformation is not limited in this application.

The following specifically describes a process of performing positive sequencing, reverse sequencing, or linear transformation on the N bit sequences, inputting the N bit sequences into M encoders, and encoding the N bit sequences.

(1) Encoding after positive sequencing:

During encoding, the N bit sequences obtained after positive sequencing may be sequentially input, according to a bit order of the bit sequences and a time-domain position ascending order or a frequency-domain position ascending order of encoding blocks in an encoder, into encoding sub-blocks of encoding blocks in a first encoder, and then the N bit sequences input into the first encoder are encoded, so as to obtain a first encoded sequence encoded.

A process of inputting the N bit sequences into the first encoder is as follows:
An $i^{th}$ bit sequence of the N bit sequences is input, according to the bit order of the bit sequences and the time-domain position ascending order of encoding blocks in an encoder, into an $i^{th}$ encoding sub-block of an $i^{th}$ encoding block in the first encoder, where i is a positive integer, and $1 \leq i \leq P$.

(2) Encoding after reverse sequencing:

The N preprocessed bit sequences are sequentially input, according to the bit order of the bit sequences and a time-domain position ascending order or a frequency-domain position descending order of encoding blocks in an encoder, into encoding sub-blocks of encoding blocks in a second encoder, and the N bit sequences input into the second encoder are encoded, to obtain a second encoded sequence. Optionally, reverse sequencing may alternatively be performed on all of the N bit sequences first, and then each of the N bit sequences obtained after reverse sequencing is input, according to the bit order of the bit sequences and the time-domain position ascending order or the frequency-domain position ascending order of encoding blocks in an encoder, into an encoding sub-block of an encoding block in a second encoder. Any preprocessing that can achieve the same objective can be used. Specific preprocessing performed on all of the N bit sequences is not limited in this application.

A process of inputting the N bit sequences into the second encoder is as follows:

A $j^{th}$ bit sequence of the N bit sequences is input, according to the bit order of the bit sequences and the time-domain position descending order or the frequency-domain position descending order of encoding blocks in an encoder, into a $j^{th}$ encoding sub-block of a $j^{th}$ encoding block in the second encoder, where j is a positive integer, and $1 \leq j \leq P$.

(3) Encoding after linear transformation:

The N bit sequences obtained after linear transformation are input, according to the bit order of the bit sequences and the time-domain position ascending order or the frequency-domain position ascending order of encoding blocks in an encoder, into encoding sub-blocks of encoding blocks in a third encoder, and the N bit sequences input into the third encoder after linear transformation are encoded, to obtain a third encoded sequence.

Linear transformation is performed for (M - 2) times, and a quantity of the third encoders is at least one. Correspondingly, a process of performing linear transformation on the N bit sequences is as follows:
First, linear transformation is performed on the N bit sequences that are to be input into a $k^{th}$ third encoder, to obtain N new bit sequences, where k is a positive integer, and $1 \leq k \leq N$.

Then, an $m^{th}$ new bit sequence of the N new bit sequences is input into an $m^{th}$ encoding sub-block of an $m^{th}$ encoding block in the $k^{th}$ third encoder, where m is a positive integer, and $1 \leq m \leq P$.

A matrix for linear transformation may satisfy the following formula:

$$\begin{bmatrix} b_{j,1} & b_{j,2} & \Lambda & b_{j,N} \end{bmatrix} = \begin{bmatrix} a_1 & a_2 & \Lambda & a_N \end{bmatrix} \times \boldsymbol{F}_j \quad , \quad \text{where} \quad b_{j,1} \quad b_{j,2} \quad \Lambda \quad b_{j,N}$$

where $b_{j,1}$ $b_{j,2}$ $\wedge$ $b_{j,N}$ represent the N new bit sequences obtained after linear transformation is performed on N bit sequences to be input into a $j^{th}$ third encoder, $a_1$ $a_2$ $\wedge$ $a_N$ represent the N bit sequences to be input into the $j^{th}$ third encoder, and $\boldsymbol{F}_j$ represents the matrix for linear transformation. Transformation may be further performed based on the formula used in this application, to obtain another formula of linear transformation. A specific formula of linear transformation is not limited in this application.

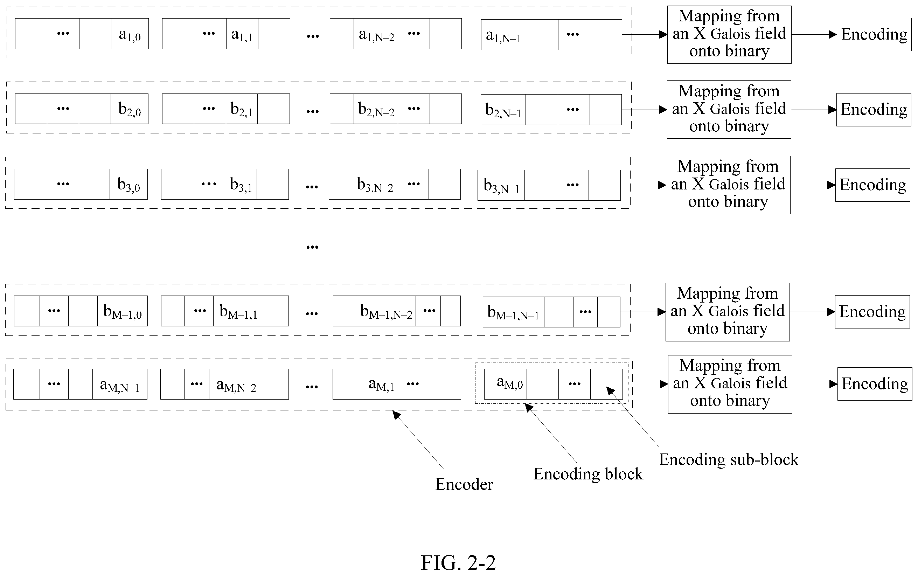

FIG. 2-2 is a schematic diagram of layout of the N bit sequences input into (M-2) encoders after (M-2) times of linear transformation. In FIG. 2-2, $M \geq 3$. $b_{3,N-1}$ represents an $N^{th}$ bit sequence of N bit sequences input into a $3^{rd}$ third encoder after linear transformation. Other cases are similar, and details are not described again.

Optionally, to simplify an encoding operation process for currently input bit sequences and to improve encoding efficiency, bit sequences in some encoding sub-blocks may be further frozen, so that the bit sequences become known bit sequences. Alternatively, the encoding sub-blocks may be initialized, so as to help input subsequent bit sequences. Specifically, after the N bit sequences are preprocessed, and before the N bit sequences preprocessed each time are input, according to a position arrangement order of encoding sub-blocks of an encoding block in an encoder, into encoding blocks of one of the M encoders, an encoding sub-block in the first encoder other than an $i^{th}$ encoding sub-block, an encoding sub-block in the second encoder other than a $j^{th}$ encoding sub-block, and an encoding sub-block in the $k^{th}$ third encoder other than an $m^{th}$ encoding sub-block may be set to zero. The encoding operation process can be simplified and the encoding efficiency can be improved in a manner of setting zero. It should be noted that, setting zero mentioned herein and in the following description may be further setting one, or setting any known value. For ease of description, setting zero is used as an example for description herein and in the following description. Details are not described again in the following description.

104. Respectively send the M obtained encoded sequences on M parallel channels through resource mapping.

Compared with that in an existing mechanism, in this embodiment of this application, a transmit device does not need to know a capacity of a single parallel channel. Before inputting repeated data into an encoder, the transmit device may first preprocess the repeated data, and then input, according to the position arrangement order of encoding sub-blocks of an encoding block in an encoder, repeated data preprocessed each time into encoding sub-blocks of encoding blocks in one of the M encoders. In this way, it can be ensured that all bit sequences input into the encoder are input into corresponding encoding sub-blocks according to a rule. Therefore, the N bit sequences can be correctly sent, a preset channel capacity can be reached through a coding gain, and a receive device can correctly decode the N bit sequences.

In some embodiments of the present invention, before the N bit sequences obtained after linear transformation are input into the third encoder, the N new bit sequences may be further mapped onto an X Galois field, where $X=2^p$, and p is a positive integer.

After the N bit sequences obtained after linear transformation are input into the third encoder, and before the N bit sequences input into the third encoder after linear transformation are encoded, the N new bit sequences that are mapped onto the X Galois field and that are input into the j$^{th}$ third encoder may be further mapped onto binary sequences.

That the N bit sequences are mapped onto the X Galois field includes one of the following:

when $M \leq 4$, the N bit sequences are mapped onto a binary field; or

when $M>4$, the N bit sequences are mapped onto a q-nary Galois field $2^q$, where q is a positive integer greater than or equal to 2.

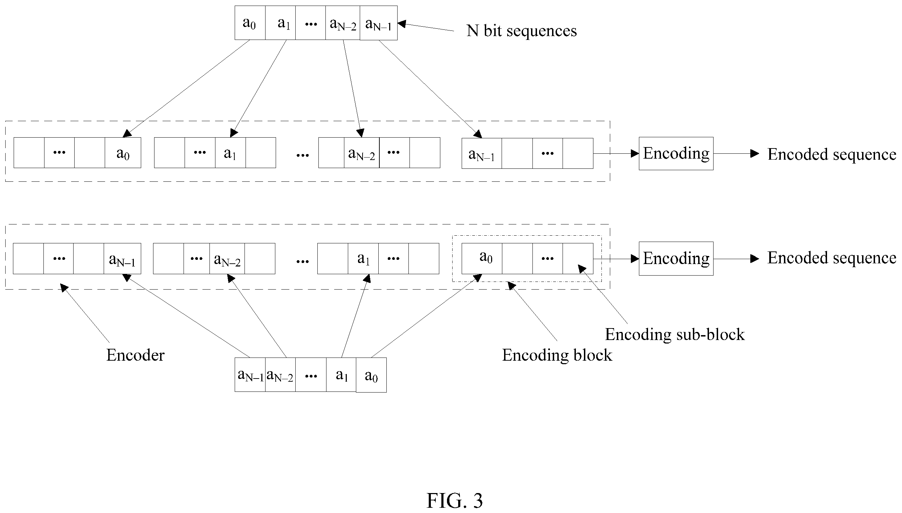

FIG. 3 is a schematic diagram of inputting N bit sequences (including $a_0$, $a_1$, $a_2$, ..., $a_{N-2}$, and $a_{N-1}$) into two parallel channels for transmission, that is, in an M=2 scenario. In the M=2 scenario, $a_0$, $a_1$, $a_2$, ..., $a_{N-2}$, and $a_{N-1}$ need to be preprocessed for two times, so as to obtain two pieces of repeated data. Each piece of repeated data needs to be input, according to a bit order of bits in the repeated data and arrangement order of positions of encoding sub-blocks of an encoding block in an encoder into which the repeated data is to be input, into a corresponding encoder. The following uses two preprocessing manners as an example: positive sequencing and reverse sequencing, Details are as follows:

For repeated data obtained through positive sequencing: The N bit sequences (including bit sequences $a_0$, $a_1$, $a_2$, ..., $a_{N-2}$, and $a_{N-1}$) are separately placed on input ends of N contiguous encoding blocks of a first encoder. $a_0$ is placed in an encoding sub-block whose index is 0 in a first encoding block, $a_1$ is placed in an encoding sub-block whose index is 1 in a second encoding block, $a_2$ is placed in an encoding sub-block whose index is 2 in a third encoding block, and so on, $a_{N-1}$ is placed in an encoding sub-block whose index is N in an N$^{th}$ encoding block. Then, $a_0$, $a_1$, $a_2$, ..., $a_{N-2}$, and $a_{N-1}$ input into the first encoder are encoded, or encoding may be performed after input ends of all encoding blocks in the first encoder are full of bit sequences. An encoding time sequence is not limited in this application.

For repeated data obtained through reverse sequencing: Reverse sequencing is performed to change the N bit sequences (including bit sequences $a_0$, $a_1$, $a_2$, ..., $a_{N-2}$, and $a_{N-1}$) to ($a_{N-1}$, $a_{N-2}$, ..., $a_1$, $a_0$), and then ($a_{N-1}$, $a_{N-2}$, ..., $a_1$, $a_0$) are separately placed on input ends of N contiguous encoding blocks of a second encoder. $a_{N-1}$ is placed in an encoding sub-block whose index is 0 in a first encoding block, $a_{N-2}$ is placed in an encoding sub-block whose index is 1 in a second encoding block, and so on, $a_1$ is placed in an encoding sub-block whose index is N-2 in a third encoding block, and $a_0$ is placed in an encoding sub-block whose index is N-1 in an N$^{th}$ encoding block. Similarly, $a_0$, $a_1$, $a_2$, ..., $a_{N-2}$, and $a_{N-1}$ input into the second encoder are encoded, or encoding may be performed after input ends of all encoding blocks in the second encoder are full of bit sequences.

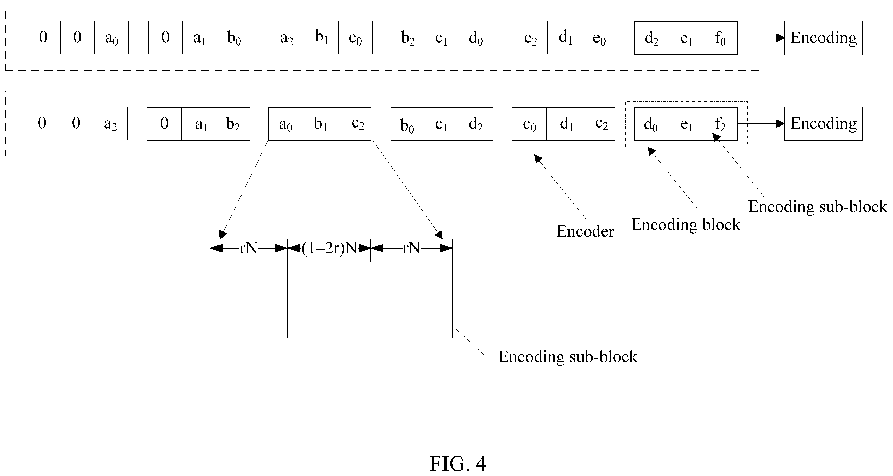

Characteristics, such as the encoder, the encoding block, the encoding sub-block, the arrangement order of positions of encoding sub-blocks in an encoding block, the preprocessing manner, the rule of inputting a bit sequence into an encoding sub-block, the encoding rule, the matrix for linear transformation, the lengths of bit sequences input into encoding sub-blocks, the X Galois field, and the coding matrix, are also applicable to all embodiments (including an embodiment corresponding to any one of FIG. 4 to FIG. 12) in subsequent content in this application. Similar details in the subsequent content are not described again.

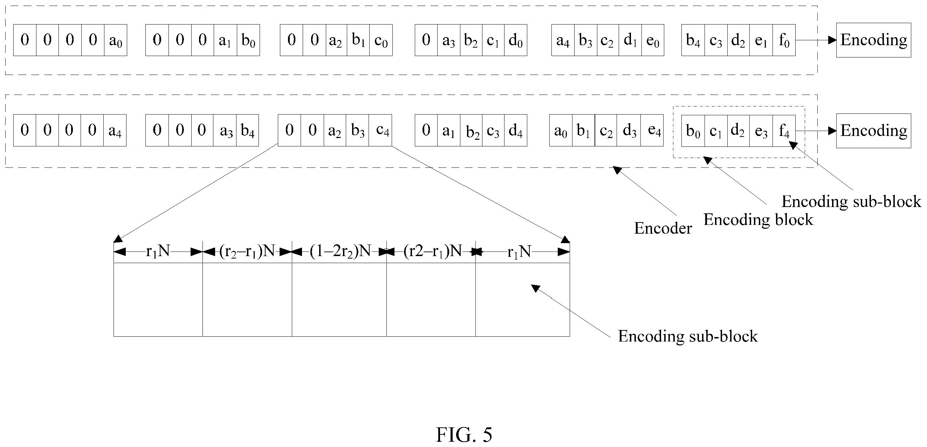

In some other application scenarios, considering that encoders need to simultaneously encode at least two data streams, the at least two data streams may still be separately input, according to a position arrangement order of encoding sub-blocks of an encoding block in an encoder, into M encoders, and then bit sequences in a same encoder are encoded. An order of inputting data streams into encoders and an encoding rule of encoding the data streams input into the encoders may be further set to improve encoding efficiency and encoder utilization. The at least two data streams are input into a same encoder according to a uniform rule, and the at least two data streams are encoded according to the encoding rule, so that encoding efficiency can be improved, a coding gain can be ensured, and a combined capacity can reach 1 based only on a combined capacity of M channels without a need to know a capacity of every channel. FIG. 4 and FIG. 5 are two schematic diagrams of encoding a plurality of data streams in two parallel channels.

In FIG. 4, a data steam a ($a_0$, $a_1$, and $a_2$), a data steam b ($b_0$, $b_1$, and $b_2$), a data steam c ($c_0$, $c_1$, and $c_2$), a data steam d ($d_0$, $d_1$, and $d_2$), a data steam e ($e_0$, $e_1$, and $e_2$), and a data steam f (fo, fi, and f2) are separately input into two encoders for encoding.

In FIG. 5, a data steam a ($a_0$ to $a_4$), a data steam b ($b_0$ to $b_4$), a data steam c ($c_0$ to $c_4$), a data steam d ($d_0$ to $d_4$), a data steam e ($e_0$ to $e_4$), and a data steam f ($f_0$ to $f_4$) are separately input into two encoders for encoding.

In FIG. 4 and FIG. 5, encoding sub-blocks are first set to zero, and then the data streams are separately input. Lengths of encoding blocks are the same, encoding sub-blocks in the encoding blocks may be of a same length or different lengths, and a length of an encoding sub-block indicates a quantity of bits that can be accommodated in the encoding sub-block. As shown in FIG. 4, assuming that a length of one encoding block is N (in other words, N encoding sub-blocks are included), in an encoding block in which $a_0$, $b_1$, and $c_2$ are located, a length of an encoding sub-block in which $a_0$ is located is rN, a length of an encoding sub-block in which $b_1$ is located is (1-2r)N, and a length of an encoding sub-block in which $c_2$ is located is rN. This is similar in FIG. 5, and details are not described again.

For encoding in FIG. 4 and FIG. 5, encoding may be performed after the encoders are full of bit sequences; or encoding may be sequentially performed according to an order of inputting the data streams are input into the encoders; or some or all bit sequences of a data stream that is previously input are encoded after a next data steam is input. In addition, during encoding of the data stream that is previously input, some bit sequences that are input this time may also be encoded. A specific encoding rule may be flexibly selected based on an actual encoding requirement, and is not specifically limited in this application.

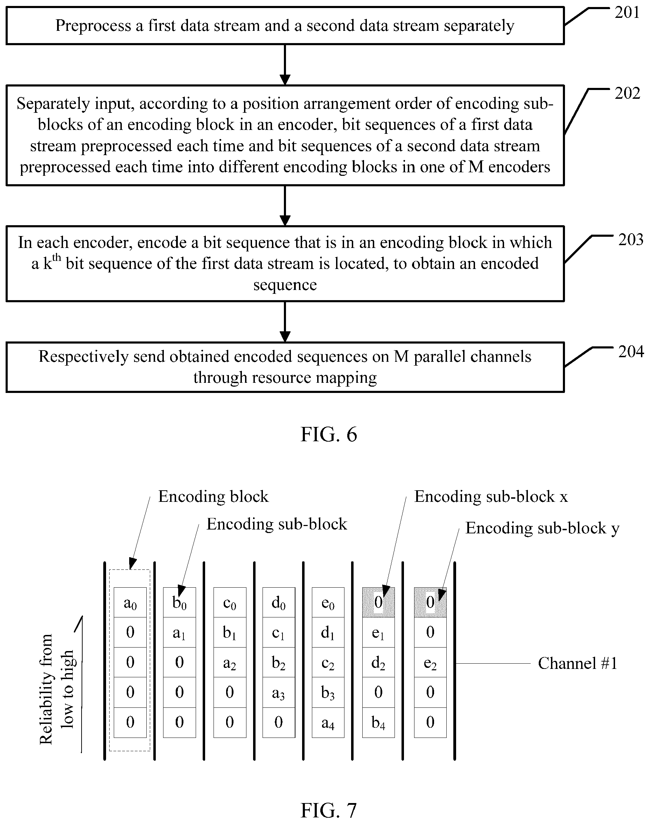

In actual application, when the at least two data streams are separately input into the encoders, a time sequence of inputting the data streams may be specified. Assuming that a data stream 1, a data stream 2, and a data steam 3 need to be simultaneously encoded, the data steam 1, the data stream 2, and the data stream 3 may be sequentially input into corresponding encoders in a time sequence according to an encoding rule, and then the data streams are encoded. Alternatively, after some bit sequences of the data stream 1 and some data streams of the data steam 2 are input into the encoders, the bit sequences of the data stream 1 input into the encoders may be encoded; after some bit sequences of the data steam 3 are input into the encoders, the bit sequences that are of the data streams 1 and 2 and that are input into the encoders are encoded; and so on, until encoding of all bit sequences are completed. Referring to FIG. 6, the following describes encoding a first data stream and a second data stream of a plurality of data streams input into M encoders.

201. Preprocess a first data stream and a second data stream separately.

The first data stream includes $N_1$ bit sequences, the second data stream includes $N_2$ bit sequences, $N_1$ and $N_2$ are positive integers, and $N_1$ and $N_2$ may be equal or may not be equal. The data streams may be divided based on a bit capacity of an idle encoding sub-block in a current encoder, for example, when some current idle encoding sub-blocks have a relatively large bit capacity, bit sequences with a relatively large quantity of bits may be obtained through division, so that the bit sequences are placed in the encoding sub-blocks with a relatively large bit capacity; or data streams may be divided based on importance of bit sequences in the data streams, or bit order of a bit sequence having high importance may be changed with reference to a preprocessing manner, so that the bit sequence having high importance is input into an encoding sub-block having high reliability as far as possible. Values of $N_1$ and $N_2$ are variable, and a specific division rule is not limited in this application.

202. Separately input, according to a position arrangement order of encoding sub-blocks of an encoding block in an encoder, bit sequences of a first data stream preprocessed each time and bit sequences of a second data stream preprocessed each time into encoding sub-blocks of different encoding blocks in one of M encoders.

M≥2, and in each encoder, a (k+1)th bit sequence of the first data stream and a kth bit sequence of the second data stream are located in a same encoding block, where k is a positive integer.

203. In each encoder, encode a bit sequence that is in an encoding block in which a kth bit sequence of the first data stream is located, to obtain an encoded sequence.

The kth bit sequence of the second data stream is located in an encoding sub-block that has highest reliability in an encoding block.

204. Respectively send obtained encoded sequences on M parallel channels through resource mapping,

Compared with that in an existing mechanism, in this application, a transmit device does not need to know a capacity of a single parallel channel, and before inputting data streams into an encoder, the transmit device first preprocesses bit sequences of the data streams, and then inputs, according to the position arrangement order of encoding sub-blocks of an encoding block in an encoder, bit sequences preprocessed each time into encoding sub-blocks of encoding blocks in one of the M encoders. In this way, it can be ensured that all bit sequences input into the encoder are input into corresponding encoding sub-blocks according to a rule. Therefore, the bit sequences can be correctly sent, a preset channel capacity can be reached through a coding gain, and a receive device can correctly decode the bit sequences.

It should be noted that, because of factors such as a difference in sizes of a plurality of data streams input into a same encoder and a difference in quantities of bits that have high importance and that are in the data streams, quantities of bit sequences obtained by dividing the plurality of data streams may be different. There may be the two following cases: In one case, a data stream input later may finally occupy less encoding blocks while a data stream input earlier may occupy more encoding blocks; in the other case, after a last data stream is input into encoding blocks, no new data streams are input into the encoder, and an input end of the encoder is not full of bit sequences. In the two cases, some bit sequences that are previously input cannot be encoded according to the encoding rule described in step 203; therefore, in both cases, rest bit sequences may be directly encoded without waiting. In this way, encoding efficiency can be improved, and unnecessary waiting can be avoided.

In the following description, encoding a data stream a, a data stream b, a data stream c, a data stream d, and a data stream e is used as an example.

As shown in FIG. 7, a data stream a ($a_0$ to $a_5$), a data stream b ($b_0$ to $b_4$), a data stream c ($c_0$ to $c_2$), a data stream d ($d_0$ to $d_2$), and a data stream e ($e_0$ to $e_2$) are input into a same encoder. $a_0$, $b_0$, $c_0$, $d_0$, and $e_0$ are all located on positions of encoding sub-blocks that have highest reliability in encoding blocks in which $a_0$, $b_0$, $c_0$, $d_0$, and $e_0$ are located. Therefore, after $a_0$ to $a_2$ are input, bit sequences in the encoding block in which $a_0$ is located are encoded; after $b_0$ to $b_4$ are input, bit sequences (including $b_0$ and $a_1$) in the encoding block in which $b_0$ is located are encoded; after $c_0$ to $c_2$ are input, bit sequences (including $c_0$, $b_1$, and $a_2$) in the encoding block in which $c_0$ is located are encoded; after $d_0$ to $d_2$ are input, bit sequences (including $d_0$, $c_1$, $b_2$, and $a_4$) in the encoding block in which $d_0$ is located are encoded; and after $e_0$ to $e_2$ are input, bit sequences (including $e_0$, $d_1$, $c_2$, $b_3$, and $a_5$) in the encoding block in which $a_4$ is located are encoded. Finally, $e_1$, $d_2$, $b_4$, and $e_2$ remain unencoded. Therefore, no matter whether bit sequences are to be input into an encoding sub-block x and an encoding sub-block y in FIG. 7 in a subsequent period of time, to ensure encoding efficiency, bit sequences (including $e_1$, $d_2$, and $b_4$) in an encoding block in which $e_1$ is located and bit sequences (including $e_2$) in an encoding block in which $e_2$ is located may be directly encoded without waiting.

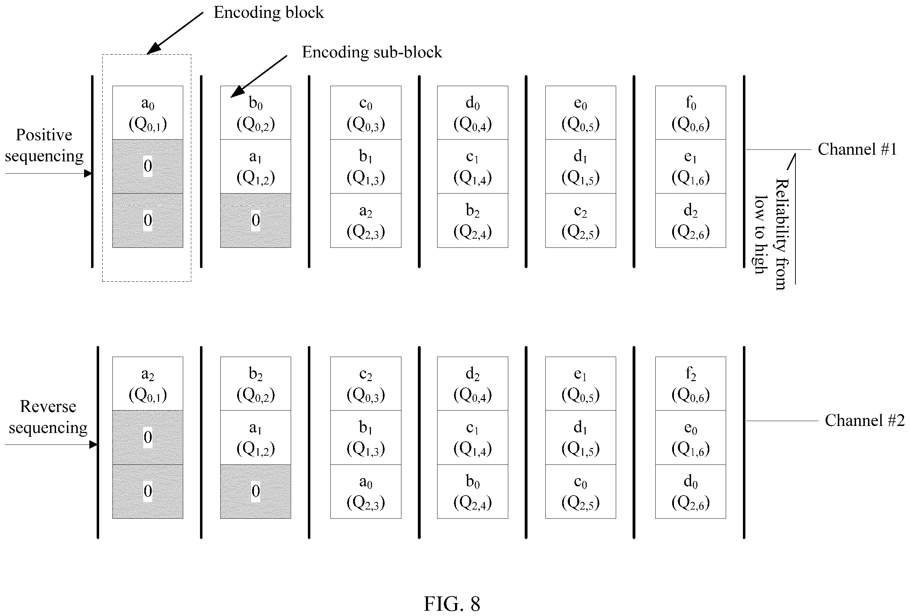

As shown in FIG. 8, a data stream a ($a_0$ to $a_2$), a data stream b ($b_0$ to $b_2$), a data stream c ($c_0$ to $c_2$), a data stream d ($d_0$ to $d_2$), a data stream e ($e_0$ and $e_1$), and a data stream f ($f_0$ to $f_2$) that are obtained through positive sequencing are input into an encoder corresponding to a channel #1, and a data stream a ($a_0$ to $a_2$), a data stream b ($b_0$ to $b_2$), a data stream c ($c_0$ to $c_2$), a data stream d ($d_0$ to $d_2$), a data stream e ($e_0$ and $e_1$), and a data stream f ($f_0$ to $f_2$) that are obtained through reverse sequencing are input into the encoder corresponding to the channel #1. Bit sequences of a same data stream have a diagonal relationship, for example, $a_0$, $a_1$, and $a_2$ have a diagonal relationship, and the others are similar. For the channel #1, after $a_0$ to $a_2$ are input, bit sequences in an encoding block in which $a_0$ is located are encoded; after $b_0$ to $b_2$ are input, bit sequences in an encoding block in which $b_0$ is located are encoded; after $c_0$ to $c_2$ are input, bit sequences in an encoding block in which $c_1$ is located are encoded; after $d_0$ to $d_2$ are input, bit sequences in an encoding block in which $d_0$ is located are encoded; after $e_0$ and $e_1$ are input, bit sequences in an encoding block in which $e_0$ is located are encoded; and after fo is input, bit sequences in an encoding block in which fo is located are encoded. Then, bit sequences in an encoder in which encoding sub-blocks shown by shade blocks are located are encoded. This is similar for a channel #2. Details are not described again.

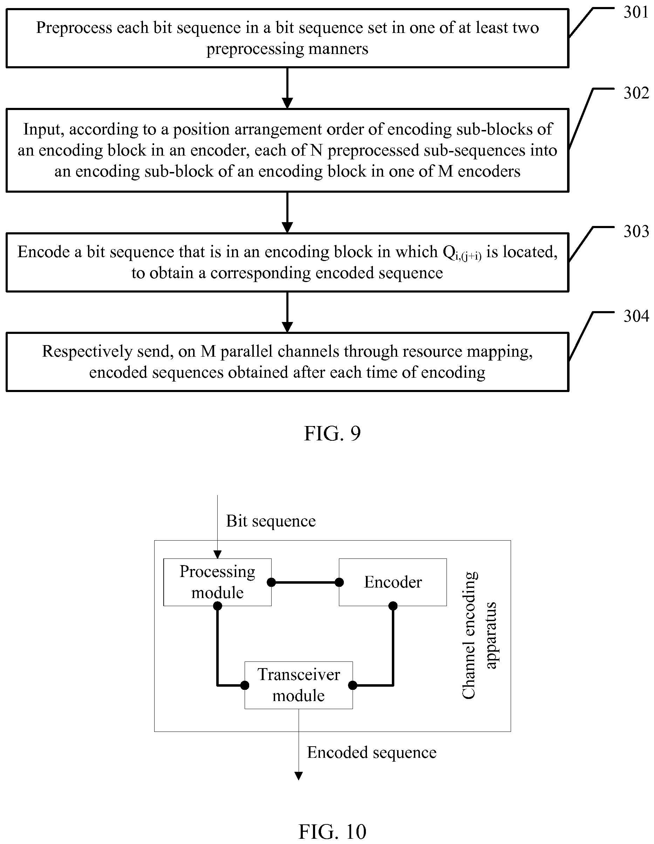

Referring to FIG. 9, the following describes encoding each bit sequence in a bit sequence set input into M encoders.

301. Preprocess each bit sequence in the bit sequence set in one of at least two preprocessing manners.

The bit sequence set includes at least two bit sequences, each bit sequence includes N sub-sequences, and N is a positive integer.

In a process of preprocessing different bit sequences, different bit sequences may be preprocessed in different manners or in a same manner, and a quantity of preprocessing times of different bit sequences may be the same or different. This is not specifically limited in this application.

302. Input, according to a position arrangement order of encoding sub-blocks of an encoding block in an encoder, each of N preprocessed sub-sequences into an encoding sub-block of an encoding block in one of the M encoders.

A position of an $i^{th}$ encoding sub-block that is of a $(j+i)^{th}$ encoding block and that is corresponding to an $i^{th}$ sub-sequence of a $j^{th}$ bit sequence in the bit sequence set is represented by $Q_{i,(j+i)}$, $i<N$, i is a nonnegative integer, and j and M are positive integers. It should be noted that, in this application, j of the $j^{th}$ bit sequence is an index of the $j^{th}$ bit sequence in the bit sequence set. Similarly, i of the $i^{th}$ encoding sub-block is an index of the $i^{th}$ encoding sub-block in an encoding block to which the encoding sub-block belongs. For example, the bit sequence set includes four bit sequences, a first bit sequence of the bit sequence set includes 20 sub-sequences, and a first sub-sequence of the 20 sub-sequences may be referred to as a $0^{th}$ sub-sequence. Therefore, a $0^{th}$ encoding sub-block indicates that an index of the encoding sub-block in an encoding block to which the encoding sub-block belongs is 0, and a position, of the $0^{th}$ encoding sub-block in a first encoding block, corresponding to the $0^{th}$ sub-sequence in the first bit sequence is $Q_{0,1}$. The others are similar.

Optionally, bit sequences in at least two encoders are preprocessed in different manners.

Sub-sequences of a same bit sequence need to be preprocessed for at least two times. In a bit sequence obtained after each time of preprocessing, sub-sequences need to be separately input into encoding sub-blocks of different encoding blocks in a same encoder. The following three cases are included based on different preprocessing manners and a quantity of encoders required for repeated data.

1. All sub-sequences of a same bit sequence are sequentially input, according to a bit order of bits and a time-domain position ascending order or a frequency-domain position ascending order of encoding blocks in an encoder, into an encoding sub-block of an encoding block in a first encoder.
2. All sub-sequences of a same bit sequence are sequentially input, according to a bit order of bits and a time-domain position descending order or a frequency-domain position descending order of encoding blocks in an encoder, into an encoding sub-block of an encoding block in a second encoder. Alternatively, reverse sequencing may be first performed on each sub-sequence of the same bit sequence, and then all sub-sequences of the same bit sequence obtained after reverse sequencing are sequentially input, according to a bit order of bits and a time-domain position ascending order or a frequency-domain position ascending order of encoding blocks in an encoder, in to an encoding sub-block of an encoding block in a second encoder. Any preprocessing that can achieve the same objective can be used. Specific preprocessing performed on each sub-sequence of the bit sequence is not limited in this application.
3. Each sub-sequence of a same bit sequence obtained after linear transformation is input, according to a bit order of bits and the time-domain position ascending order or the frequency-domain position ascending order of encoding blocks in an encoder, into an encoding sub-block of an encoding block in a third encoder.

When M=2, after one time of positive sequencing, to-be-encoded bit sequences may be input into one encoder; and after one time of linear transformation, bit sequences obtained are input into another encoder. Alternatively, after one time of positive sequencing, to-be-encoded bit sequences are input into one encoder; and after one time of reverse sequencing, bit sequences obtained are then input into another encoder.

When M≥3, preprocessing including one time of positive sequencing, one time of reverse sequencing, and (M-2) times of linear transformation needs to be performed on to-be-encoded bit sequences. A same formula or different formulas may be used in preprocessing of the (M-2) times of linear transformation. A specific formula used in the (M-2) times of linear transformation is not limited in this application. In addition, when M≥3, linear transformation is performed for at least once, and a quantity of the third encoders is at least one.

Optionally, to simplify an encoding operation process for currently input bit sequences and to improve encoding efficiency, bit sequences in some encoding sub-blocks may be further frozen, so that the bit sequences become known bit sequences. Alternatively, the encoding sub-blocks may be initialized, so as to help input subsequent bit sequences. Specifically, after a first preprocessed bit sequence is input into encoding sub-blocks of encoding blocks in one of the M encoders, an encoding sub-block, other than the position Qi,(i+i), in the encoder into which the first preprocessed bit sequence is currently input may be set to zero.

303. Encode a bit sequence that is in an encoding block in which $Q_{i,(j+i)}$ is located, to obtain a corresponding encoded sequence.

Specifically, in each encoder, a bit sequence that is in an encoding block in which an $i^{th}$ sub-sequence of a $j^{th}$ bit sequence is located, a bit sequence that is in an encoding block in which an $i^{th}$ sub-sequence of a $(j+1)^{th}$ bit sequence is located, and a bit sequence that is in an encoding block in which an $i^{th}$ sub-sequence of a $(j+2)^{th}$ bit sequence is located may be encoded sequentially.

During encoding, a coding matrix corresponding to a processing type of preprocessing in an encoder may be invoked based on the processing type, and a preprocessed bit sequence set and the coding matrix are multiplied, to obtain a corresponding encoded sequence. In the embodiment corresponding to FIG. 9, a matrix for linear transformation satisfies:

$$\begin{bmatrix} b_{k,1} & b_{k,2} & \Lambda & b_{k,N} \end{bmatrix} = \begin{bmatrix} a_1 & a_2 & \Lambda & a_N \end{bmatrix} \times \boldsymbol{F}_k \quad , \quad \text{where} \quad b_{k,1} \quad b_{k,2} \quad \Lambda \quad b_{k,N}$$

where $b_{k,1}$ $b_{k,2}$ $\wedge$ $b_{k,N}$ represent sub-sequences of a same bit sequence input into a $k^{th}$ third encoder after linear transformation, $a_1$ $a_2$ $\wedge$ $a_N$ separately represent sub-sequences of the same bit sequence that are to be input into the $k^{th}$ third encoder, $\boldsymbol{F}_k$ represents the matrix for linear transformation, N is a quantity of encoding blocks in the encoder, k and N are positive integers, and 1≤k≤N.

304. Respectively send, on M parallel channels through resource mapping, encoded sequences obtained after each time of encoding.

Compared with that in an existing mechanism, in this application, a transmit device does not need to know a capacity of a single parallel channel, and before inputting bit sequences into an encoder, the transmit device first preprocesses the bit sequences, and then inputs, according to the position arrangement order of encoding sub-blocks of an encoding block in an encoder, bit sequences preprocessed each time into encoding sub-blocks of encoding blocks in one of the M encoders. In this way, it can be ensured that all sub-sequences input into the encoder are input into corresponding encoding sub-blocks according to a rule. Therefore, each of the bit sequences can be correctly sent, a preset channel capacity can be reached through a coding gain, and a receive device can correctly decode each bit sequence.

For ease of understanding, refer to FIG. 8. The bit sequence set may include a bit sequence a (including sub-sequences $a_0$ to $a_2$), a bit sequence b (including sub-sequences $b_0$ to $b_2$), a bit sequence c (including sub-sequences $c_0$ to $c_2$), and a bit sequence d (including sub-sequences $d_0$ to $d_2$). The bit sequences a to d may be respectively referred to as a first to a fourth bit sequence. Therefore, in the channel #1, positions of encoding sub-blocks respectively corresponding to sub-sequences $a_0$ to $a_2$, $b_0$ to $b_2$, $c_0$ to $c_2$, and $d_0$ to $d_2$ are as follows:

Qo,i represents a position, corresponding to an encoding sub-block whose index is #0 in encoding sub-blocks of a first encoding block, of $a_0$ of the bit sequence a, the encoding sub-block whose index is #0 is referred to as encoding sub-block #0 for short, and the following is the same;
$Q_{1,2}$ represents a position, corresponding to an encoding sub-block #1 of a second encoding block, of $a_1$ of the bit sequence a;
$Q_{2,3}$ represents a position, corresponding to an encoding sub-block #2 of a third encoding block, of $a_2$ of the bit sequence a;
$Q_{0,2}$ represents a position, corresponding to an encoding sub-block #0 of the second encoding block, of $b_0$ of the bit sequence b;
$Q_{1,3}$ represents a position, corresponding to an encoding sub-block #1 of the third encoding block, of $b_1$ of the bit sequence b;
$Q_{2,4}$ represents a position, corresponding to an encoding sub-block #2 of a fourth encoding block, of $b_2$ of the bit sequence b;
$Q_{0,3}$ represents a position, corresponding to an encoding sub-block #0 of the third encoding block, of $c_0$ of the bit sequence c;
$Q_{1,4}$ represents a position, corresponding to an encoding sub-block #1 of the fourth encoding block, of $c_1$ of the bit sequence c;
$Q_{2,5}$ represents a position, corresponding to an encoding sub-block #2 of a fifth encoding block, of $c_2$ of the bit sequence c;
$Q_{0,4}$ represents a position, corresponding to an encoding sub-block #0 of the fourth encoding block, of $d_0$ of the bit sequence d;
$Q_{1,5}$ represents a position, corresponding to an encoding sub-block #1 of the fifth encoding block, of $d_1$ of the bit sequence d;
$Q_{2,6}$ represents a position, corresponding to an encoding sub-block #2 of a sixth encoding block, of $d_2$ of the bit sequence d;
$Q_{0,5}$ represents a position, corresponding to an encoding sub-block #0 of the fifth encoding block, of $e_0$ of the bit sequence e;
$Q_{1,6}$ represents a position, corresponding to an encoding sub-block #1 of the sixth encoding block, of $e_1$ of the bit sequence e; and
$Q_{0,6}$ represents a position, corresponding to an encoding sub-block #0 of the sixth encoding block, of fo of the bit sequence f;

For the channel #1, after $a_0$ to $a_2$ are input, bit sequences in the encoding block in which $Q_{0,1}$ is located are encoded; after $b_0$ to $b_2$ are input, bit sequences in the encoding block in which $Q_{0,2}$ is located are encoded; after $c_0$ to $c_2$ are input, bit sequences in the encoding block in which $Q_{0,3}$ is located are encoded; and after $d_0$ to $d_2$ are input, bit sequences in the encoding block in which $Q_{0,4}$ is located are encoded. Then, bit sequences in an encoder in which encoding sub-blocks shown by shade blocks are located are encoded. This is similar for the channel #2. Details are not described again.

Optionally, sub-sequences of a same bit sequence may be of a same length or different lengths. Lengths of the sub-sequences may be determined based on factors such as a length of an actual idle encoding sub-block and importance of the sub-sequences. This is not specifically limited in this application. In addition, sub-sequences of each piece of repeated data are preprocessed for a plurality of times; however, it needs to ensure that a length of a first encoding sub-block is the same as that of a second encoding sub-block. The first encoding sub-block is an encoding sub-block in one encoder into which a first sub-sequence of the bit sequence set is input after the first sub-sequence is preprocessed once, and the second encoding sub-block is an encoding sub-block of another encoder into which the first sub-sequence is input after the first sub-sequence is preprocessed for another time.

The channel coding method in this application is described above, and the following describes a channel coding apparatus that performs the channel coding method. The channel coding apparatus includes a processing module, an encoder, and a transceiver module. Each encoder includes at least N idle encoding blocks that are contiguous in time-domain positions or frequency-domain positions, each encoding block includes P encoding sub-blocks, reliability of the P encoding sub-blocks is sorted in ascending order based on a time-domain ascending order or frequency-domain ascending order, P is a positive integer, and P≥N.

1. Referring to FIG. 10, a channel coding apparatus is described. The channel coding apparatus includes:

a processing module, configured to preprocess N bit sequences, and input, according to a position arrangement order of encoding sub-blocks of an encoding block in an encoder, N bit sequences preprocessed each time into encoding sub-blocks of encoding blocks in one of M encoders, where N and M are positive integers, and M≥2; encoders, configured to encode the N preprocessed bit sequences input into the encoders, to obtain M corresponding encoded sequences; and a transceiver module, configured to respectively send, on M parallel channels, the M encoded sequences obtained through encoding.

In this embodiment of this application, the processing module does not need to know a capacity of a single parallel channel, and before inputting repeated data into an encoder, the processing module may first preprocess the repeated data, and then input, according to the position arrangement order of encoding sub-blocks of an encoding block in an encoder, repeated data preprocessed each time into encoding sub-blocks of encoding blocks in one of M encoders. In this way, it can be ensured that all bit sequences input into the encoder are input into corresponding encoding sub-blocks according to a rule. Therefore, the N bit sequences can be correctly sent, a preset channel capacity can be reached through a coding gain, and a receive device can correctly decode the N bit sequences.

Optionally, in some embodiments of the present invention, the processing module is specifically configured to:

sequentially input, according to a bit order of the bit sequences and a time-domain position ascending order or a frequency-domain position ascending order of encoding blocks in an encoder, the N bit sequences into encoding sub-blocks of encoding blocks in a first encoder, and encode, by using the first encoder, the N bit sequences input into the first encoder, to obtain a first encoded sequence; and further includes at least one of the following two items:

sequentially inputting, according to the bit order of the bit sequences and a time-domain position descending order or a frequency-domain position descending order of encoding blocks in an encoder, the N bit sequences into encoding sub-blocks of encoding blocks in a second encoder, and encoding, by using the second encoder, the N bit sequences input into the second encoder, to obtain a second encoded sequence; or inputting, according to the bit order of the bit sequences and the time-domain position ascending order or the frequency-domain position ascending order of encoding blocks in an encoder, the N bit sequences obtained after linear transformation into encoding sub-blocks of encoding blocks in a third encoder, and encoding, by using the third encoder, the N bit sequences input into the third encoder after linear transformation, to obtain a third encoded sequence.

In some embodiments of the present invention, the processing module is specifically configured to:
input, according to the bit order of the bit sequences and the time-domain position ascending order or the frequency-domain position ascending order of encoding blocks in an encoder, an $i^{th}$ bit sequence of the N bit sequences into an $i^{th}$ encoding sub-block of an $i^{th}$ encoding block in the first encoder, where i is a positive integer, and 1≤i≤P.

Optionally, in some embodiments of the present invention, the processing module is specifically configured to:
input, according to the bit order of the bit sequences and the time-domain position descending order or the frequency-domain position descending order of encoding blocks in an encoder, a $j^{th}$ bit sequence of the N bit sequences into a $j^{th}$ encoding sub-block of a $j^{th}$ encoding block in the first encoder, where j is a positive integer, and 1≤j≤P.

Optionally, in some embodiments of the present invention, the processing module is specifically configured to:

first perform linear transformation on the N bit sequences, which is specifically performing linear transformation on N bit sequences that are to be input into a $k^{th}$ third encoder, to obtain N new bit sequences, where k is a positive integer, and 1≤k≤N; and linear transformation is performed for (M-2) times, and a quantity of the third encoders is at least one; and then input an $m^{th}$ new bit sequence of the N new bit sequences into an $m^{th}$ encoding sub-block of an $m^{th}$ encoding block in the $k^{th}$ third encoder, where m is a positive integer, and 1≤m≤P.

Optionally, a matrix for linear transformation in this embodiment of this application satisfies:

$$\left[b_{j,1} \quad b_{j,2} \quad \Lambda \quad b_{j,N}\right]=\left[a_1 \quad a_2 \quad \Lambda \quad a_N\right]\times \boldsymbol{F}_j \quad , \quad \text{where} \quad b_{j,1} \quad b_{j,2} \quad \Lambda \quad b_{j,N}$$

where $b_{j,1}$ $b_{j,2}$ $\wedge$ $b_{j,N}$ represent the N new bit sequences obtained after linear transformation is performed on N bit sequences to be input into a $j^{th}$ third encoder, $a_1$ $a_2$ $\wedge$ $a_N$ represent the N bit sequences to be input into the $j^{th}$ third encoder, and $\boldsymbol{F}_j$ represents the matrix for linear transformation.

Optionally, in some embodiments of the present invention, after the processing module preprocesses the N bit sequences and before the processing module inputs, according to the position arrangement order of encoding sub-blocks of an encoding block in an encoder, the N bit sequences preprocessed each time into encoding sub-blocks of encoding blocks in one of the M encoders, the encoders may further perform the following step:

the first encoder sets an encoding sub-block in the first encoder other than the $i^{th}$ encoding sub-block to zero, the second encoder sets an encoding sub-block in the second encoder other than the $j^{th}$ encoding sub-block to zero, and the third encoder sets an encoding sub-block in the $k^{th}$ third encoder other than the $m^{th}$ encoding sub-block to zero.

Optionally, in some embodiments of the present invention, the N bit sequences have a same length or different lengths, a length of a first encoding sub-block is the same as that of a second encoding sub-block, the first encoding sub-block is an encoding sub-block in one encoder into which a first bit sequence of the N bit sequences is input after the first bit sequence is preprocessed once, and the second encoding sub-block is an encoding sub-block of another encoder into which the first bit sequence is input after the first bit sequence is preprocessed for another time.

Optionally, in some embodiments of the present invention, during actual encoding, the encoder may invoke, based on a processing type of preprocessing, a coding matrix corresponding to the processing type in the encoder, and multiply the N preprocessed bit sequences and the coding matrix, to obtain a corresponding encoded sequence.

2. Referring to FIG. 10, a channel coding apparatus is described. The channel coding apparatus includes:

a processing module, configured to: preprocess a first data stream and a second data stream separately, where the first data stream includes $N_1$ bit sequences, the second data stream includes $N_2$ bit sequences, and $N_1$ and $N_2$ are positive integers; and separately input, according to a position arrangement order of encoding sub-blocks of an encoding block in an encoder, bit sequences of a first data stream preprocessed each time and bit sequences of a second data stream preprocessed each time into encoding sub-blocks of different encoding blocks in one of M encoders, where $M\geq2$, a $(k+1)^{th}$ bit sequence of the first data stream and a $k^{th}$ bit sequence of the second data stream are located in a same encoding block, and k is a positive integer;

an encoder, configured to encode a bit sequence that is in an encoding block in which a $k^{th}$ bit sequence of the first data stream input into the encoder is located, so as to obtain a corresponding encoded sequence, where the $k^{th}$ bit sequence of the second data stream is located in an encoding sub-block that has highest reliability in one encoding block; and

a transceiver module, configured to respectively send, on M parallel channels, encoded sequences obtained through encoding.

In this embodiment of this application, the processing module does not need to know a capacity of a single parallel channel, and before inputting data streams into an encoder, the processing module may first preprocess bit sequences of the data streams, and then input, according to the position arrangement order of encoding sub-blocks of an encoding block in an encoder, bit sequences preprocessed each time into encoding sub-blocks of encoding blocks in one of the M encoders. In this way, it can be ensured that all bit sequences input into the encoder are input into corresponding encoding sub-blocks according to a rule. Therefore, the bit sequences can be correctly sent, a preset channel capacity can be reached through a coding gain, and a receive device can correctly decode the bit sequences.

Optionally, in some embodiments of the present invention, each encoder includes at least N idle encoding blocks that are contiguous in time-domain positions or frequency-domain positions, where $N=N_1$ or $N=N_2$; and the processing module is specifically configured to:

sequentially input, according to a bit order of the bit sequences and a time-domain position ascending order or a frequency-domain position ascending order of encoding blocks in an encoder, the N bit sequences into encoding blocks in a first encoder, and encode, by using the first encoder, the N bit sequences input into the first encoder, to obtain a first encoded sequence; and
further includes at least one of the following two items:

sequentially inputting, according to the bit order of the bit sequences and a time-domain position descending order or a frequency-domain position descending order of encoding blocks in an encoder, the N bit sequences into encoding blocks in a second encoder, and encoding, by using the second encoder, the N bit sequences input into the second encoder, to obtain a second encoded sequence; or

inputting, according to the bit order of the bit sequences and the time-domain position ascending order or the frequency-domain position ascending order of encoding blocks in an encoder, the N bit sequences obtained after linear transformation into encoding blocks in a third encoder, and encoding, by using the third encoder, the N bit sequences input into the third encoder after linear transformation, to obtain a third encoded sequence.

Optionally, in some embodiments of the present invention, each encoding block includes P encoding positions, reliability of the P encoding positions is in descending order based on a time-domain ascending order, where P is a positive integer, and P≥N; and details about inputting the bit sequences into the first encoder, the second encoder, and the third encoder are as follows:

For inputting the bit sequences into the first encoder: The processing module inputs, according to the bit order of the bit sequences and the time-domain position ascending order of encoding blocks in an encoder, an $i^{th}$ bit set of the N bit sequences into an $i^{th}$ encoding position of an $i^{th}$ encoding block in the first encoder, where i is a positive integer, and 1≤i≤P.

For inputting the bit sequences into the second encoder: The processing module inputs, according to the bit order of the bit sequences and the time-domain position descending order or the frequency-domain position descending order of encoding blocks in an encoder, a $j^{th}$ bit set of the N bit sequences into a $j^{th}$ encoding position of a $j^{th}$ encoding block in the first encoder where j is a positive integer, and 1≤j≤P.

For inputting the bit sequences into the third encoder: The processing module first performs linear transformation on the N bit sequences. A specific process of linear transformation is: performing linear transformation on N bit sequences that are to be input into a $k^{th}$ third encoder, to obtain N new bit sequences, where k is a positive integer, and 1≤k≤N; and linear transformation may be performed for (M-2) times, a quantity of the third encoders is at least one.

The processing module then inputs an $m^{th}$ new bit sequence of the N new bit sequences into an $m^{th}$ encoding position of an $m^{th}$ encoding block in the $k^{th}$ third encoder, where m is a positive integer, and 1≤m≤P.

Optionally, in some embodiments of the present invention, before inputting the N bit sequences obtained after linear transformation into the third encoder, the processing module may be further configured to map the N new bit sequences onto an X Galois field, where X=$2^p$, and p is a positive integer.

In addition, after imputing the N bit sequences obtained after linear transformation into the third encoder, and before encoding the N bit sequences input into the third encoder after linear transformation, the processing module may further map, onto binary sequences, the N new bit sequences that are mapped onto the X Galois field and that are input into the $j^{th}$ third encoder.

That the N bit sequences are mapped onto the X Galois field may include one of the following:

when M≤4, the N bit sequences are mapped onto a binary field; or
when M>4, the N bit sequences are mapped onto a q-nary Galois field $2^q$, where q is a positive integer greater than or equal to 2.

Optionally, a matrix for linear transformation satisfies:

$$\begin{bmatrix} b_{j,1} & b_{j,2} & \Lambda & b_{j,N} \end{bmatrix} = \begin{bmatrix} a_1 & a_2 & \Lambda & a_N \end{bmatrix} \times \boldsymbol{F}_j \quad , \quad \text{where} \quad b_{j,1} \quad b_{j,2} \quad \Lambda \quad b_{j,N}$$

where $b_{j,1}$ $b_{j,2}$ $\wedge$ $b_{j,N}$ represent the N new bit sequences obtained after linear transformation is performed on N bit sequences to be input into a $j^{th}$ third encoder, $a_1$ $a_2$ $\wedge$ $a_N$ represent the N bit sequences to be input into the $j^{th}$ third encoder, and $\boldsymbol{F}_j$ represents the matrix for linear transformation.

Optionally, in some embodiments of the present invention, after preprocessing the first data stream and the second data stream separately, and before inputting, according to the bit order of the bit sequence and the time-domain position ascending order of encoding blocks in an encoder, the $i^{th}$ bit set of the N bit sequences into the $i^{th}$ encoding position of the $i^{th}$ encoding block in the first encoder, the processing module is further configured to:

set an encoding sub-block in the first encoder other than the $i^{th}$ encoding sub-block to zero, set an encoding sub-block in the second encoder other than the $j^{th}$ encoding sub-block to zero, and set an encoding sub-block in the $k^{th}$ third encoder other than the $m^{th}$ encoding sub-block to zero.

Optionally, in some embodiments of the present invention, the N bit sequences have a same length or different lengths, a length of a first encoding sub-block is the same as that of a second encoding sub-block, the first encoding sub-block is an encoding sub-block in one encoder into which a first bit sequence of the N bit sequences is input after the first bit sequence is preprocessed once, and the second encoding sub-block is an encoding sub-block of another encoder into which the first bit sequence is input after the first bit sequence is preprocessed for another time.

Optionally, in some embodiments of the present invention, during encoding, the encoder may invoke, based on a processing type of preprocessing, a coding matrix corresponding to the processing type in the encoder, and multiply the N preprocessed bit sequences and the coding matrix, to obtain a corresponding encoded sequence.

3. Referring to FIG. 10, a channel coding apparatus is described. The channel coding apparatus includes:

a processing module, configured to: preprocess each bit sequence in a bit sequence set in one of at least two preprocessing manners, where the bit sequence set includes at least two bit sequences, each bit sequence includes N sub-sequences, and N is a positive integer; and input, according to a position arrangement order of encoding sub-blocks of an encoding block in an encoder, each of N preprocessed sub-sequences into an encoding sub-block of an encoding block in one of M encoders, where a position of an $i^{th}$ encoding sub-block that is of a $(j+i)^{th}$ encoding block and that is corresponding to an $i^{th}$ sub-sequence of a $j^{th}$ bit sequence in the bit sequence set is represented by $Q_{i,(j+i)}$, $i<N$, i is a nonnegative integer, j and M are positive integers, and bit sequences in at least two encoders are preprocessed in different manners;

an encoder, configured to encode a bit sequence that is in the encoding block in which $Q_{i,(j+i)}$ is located, to obtain a corresponding encoded sequence; and

a transceiver module, configured to respectively send, on M parallel channels, encoded sequences obtained after each time of encoding.

Each encoder may include encoding blocks that are contiguous in time-domain positions or frequency-domain positions, each encoding block includes a plurality of encoding sub-blocks, the encoding sub-blocks in the encoding block are corresponding to reliability, and in each encoding block, reliability of encoding sub-blocks is sorted in ascending order based on a time-domain ascending order or frequency-domain ascending order.

In this embodiment of this application, the processing module does not need to know a capacity of a single parallel channel, and before inputting a bit sequence into an encoder, the processing module may first preprocess the bit sequence, and then input, according to the position arrangement order of encoding sub-blocks of an encoding block in an encoder, a bit sequence preprocessed each time into an encoding sub-block of an encoding block in one of the M encoders. In this way, it can be ensured that all sub-sequences input into the encoder are input into corresponding encoding sub-blocks according to a rule. Therefore, each of the bit sequences can be correctly sent, a preset channel capacity can be reached through a coding gain, and a receive device can correctly decode each bit sequence.

Optionally, in some embodiments of the present invention, different bit sequences may be preprocessed in different manners.

Optionally, in some embodiments of the present invention, each encoder is specifically configured to:

for bit sequences in the encoder, sequentially encode a bit sequence that is in an encoding block in which an $i^{th}$ sub-sequence of a $j^{th}$ bit sequence is located, a bit sequence that is in an encoding block in which an $i^{th}$ sub-sequence of a $(j+1)^{th}$ bit sequence is located, and a bit sequence that is in an encoding block in which an $i^{th}$ sub-sequence of a $(j+2)^{th}$ bit sequence is located.

Optionally, in some embodiments of the present invention, the processing module is specifically configured to:

sequentially input, according to a bit order of bits and a time-domain position ascending order or a frequency-domain position ascending order of encoding blocks in an encoder, all sub-sequences of a same bit sequence into encoding sub-blocks of encoding blocks in a first encoder; and

further includes at least one of the following two items:

sequentially inputting, according to the bit order of the bits and a time-domain position descending order or a frequency-domain position descending order of encoding blocks in an encoder, all sub-sequences of the same bit sequence into encoding sub-blocks of encoding blocks in a second encoder; or

inputting, according to the bit order of the bits and the time-domain position ascending order or the frequency-domain position ascending order of encoding blocks in an encoder, each sub-sequence of the same bit sequence obtained after linear transformation into an encoding sub-block of an encoding block in a third encoder.

Optionally, in some embodiments of the present invention, the preprocessing manners include linear transformation, and when $M \geq 3$, linear transformation is performed for at least once, and a quantity of the third encoders is at least one.

A matrix for linear transformation may satisfy:

$$\begin{bmatrix} b_{k,1} & b_{k,2} & \Lambda & b_{k,N} \end{bmatrix} = \begin{bmatrix} a_1 & a_2 & \Lambda & a_N \end{bmatrix} \times \boldsymbol{F}_k \quad ,$$

where $b_{k,1}$ $b_{k,2}$ $\wedge$ $b_{k,N}$ represent sub-sequences of a same bit sequence input into a $k^{th}$ third encoder after linear transformation, $a_1$ $a_2$ $\wedge$ $a_N$ separately represent sub-sequences of the same bit sequence that are to be input into the $k^{th}$ third encoder, $\boldsymbol{F}_k$ represents the matrix for linear transformation, N is a quantity of encoding blocks in the encoder, k and N are positive integers, and $1 \leq k \leq N$.

Optionally, in some embodiments of the present invention, after the processing module inputs a first preprocessed bit sequence into an encoding sub-block of an encoding block in one of the M encoders, and before the processing module encodes the bit sequence that is in the encoding block in which $Q_{i,(j+i)}$ is located, the encoder may be further configured to:

set an encoding sub-block, other than the position Qi,(i+i), in the encoder into which the first preprocessed bit sequence is currently input to zero.

Optionally, in some embodiments of the present invention, sub-sequences of a same bit sequence have a same length or different lengths, a length of a first encoding sub-block is the same as that of a second encoding sub-block, the first encoding sub-block is an encoding sub-block in one encoder into which a first sub-sequence of the bit sequence set is input after the first sub-sequence is preprocessed once, and the second encoding sub-block is an encoding sub-block of another encoder into which the first sub-sequence is input after the first sub-sequence is preprocessed for another time.

Optionally, in some embodiments of the present invention, for each encoder, during actual encoding, the encoder may invoke, based on a processing type of preprocessing, a coding matrix corresponding to the processing type in the encoder, and multiply a preprocessed bit sequence set and the coding matrix, to obtain a corresponding encoded sequence.

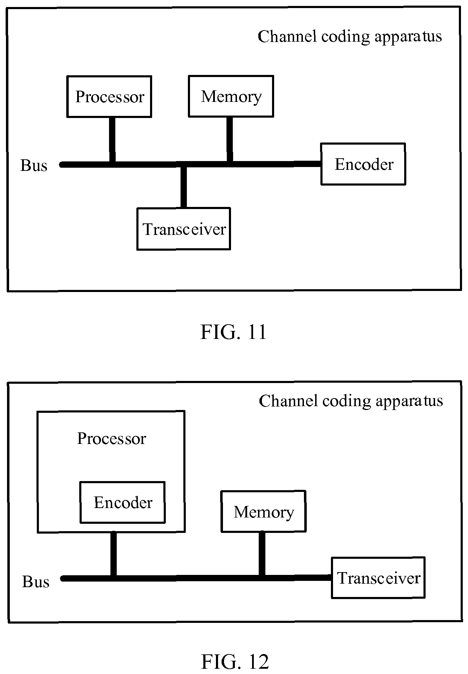

It should be noted that the encoder in this application may be an independent circuit module or may be a logic circuit implemented by software. The encoder may be implemented by software or hardware, and the encoder may be implemented by a processor by using software or may be implemented by a chip separate from a processor. This is not specifically limited in this application. For example, in the embodiments corresponding to FIG. 10 in this application, physical devices corresponding to all the transceiver modules may be transceivers, and physical devices corresponding to all the processing modules may be processors. The apparatus shown in FIG. 10 may be in a structure shown in FIG. 11 or FIG. 12. When an apparatus is in the structure shown in FIG. 11, a processor, an encoder, and a transceiver in FIG. 11 implement same or similar functions of the processing module, the encoder, and the transceiver module that are provided in the foregoing apparatus embodiment corresponding to the apparatus. Alternatively, when an apparatus is in the structure shown in FIG. 12, a processor and a transceiver in FIG. 12 implement same or similar functions of the processing module, the encoder, and the transceiver module that are provided in the foregoing apparatus embodiment corresponding to the apparatus.

Memories in FIG. 11 and FIG. 12 store program code and data that need to be invoked when the processors perform the foregoing channel coding methods.

This application further provides a computer storage medium. The medium stores a program, and when the program is executed, some or all of the steps performed by the foregoing channel coding apparatuses in the foregoing channel coding methods are performed.

In the foregoing embodiments, the description of each embodiment has respective focuses. For a part that is not described in detail in an embodiment, reference may be made to related descriptions in other embodiments.

It may be clearly understood by a person skilled in the art that, for the purpose of convenient and brief description, for a detailed working process of the system, apparatus, and module described above, reference may be made to a corresponding process in the foregoing method embodiments, and details are not described herein again.

In the several embodiments provided in this application, it should be understood that the disclosed system, apparatus, and method may be implemented in other manners. For example, the described apparatus embodiment is merely used as an example. For example, the module division is merely logical function division and may be other division in actual implementation. For example, a plurality of modules or components may be combined or integrated into another system, or some features may be ignored or not performed. In addition, the displayed or discussed mutual couplings or direct couplings or communication connections may be implemented through some interfaces. The indirect couplings or communication connections between the apparatuses or modules may be implemented in electrical, mechanical, or other forms.

The modules described as separate parts may or may not be physically separate, and parts displayed as modules may or may not be physical modules, may be located in one position, or may be distributed on a plurality of network modules. Some or all the modules may be selected according to actual needs to achieve the objectives of the solutions of the embodiments.

In addition, functional modules in the embodiments of this application may be integrated into one processing module, or each of the modules may exist alone physically, or two or more modules may be integrated into one module. The integrated module may be implemented in a form of hardware, or may be implemented in a form of a software functional module.

When the integrated module is implemented in the form of a software functional module and sold or used as an independent product, the integrated module may be stored in a computer readable storage medium. Based on such an understanding, the technical solutions of this application essentially, or the part contributing to the prior art, or all or some of the technical solutions may be implemented in the form of a software product. The computer software product is stored in a storage medium and includes several instructions for instructing a computer device (which may be a personal computer, a server, a network device, or the like) to perform all or some of the steps of the methods described in the embodiments of this application. The foregoing storage medium includes: any medium that can store program code, such as a USB flash drive, a removable hard disk, a read-only memory (English full name: Read-Only Memory, ROM for short), a random access memory (English full name: Random Access Memory, RAM for short), a magnetic disk, or an optical disc.

The technical solutions provided in this application are described in detail above. The principle and implementation of this application are described through specific examples in the embodiments of this application. The description about the embodiments is merely provided to help understand the method and core ideas of this application. In addition, persons of ordinary skill in the art can make variations and modifications in terms of the specific implementations and application scopes according to the ideas of this application. Therefore, the content of the specification shall not be construed as a limit to this application.

## Claims

1. A channel coding method, wherein the method comprises:

   preprocessing N bit sequences;
   inputting, according to a position arrangement order of encoding sub-blocks of an encoding block in an encoder, N bit sequences preprocessed each time into encoding sub-blocks of encoding blocks in one of M encoders, wherein N and M are positive integers, and M≥2;
   obtaining M corresponding encoded sequences after encoding, in the encoders, the N preprocessed bit sequences; and
   respectively sending the M obtained encoded sequences on M parallel channels.

2. The method according to claim 1, wherein each encoder comprises at least N idle encoding blocks that are contiguous in time-domain positions or frequency-domain positions, and the inputting, according to a position arrangement order of encoding sub-blocks of an encoding block, N bit sequences preprocessed each time into encoding sub-blocks of encoding blocks in one of M encoders, and encoding, in the encoders, the N preprocessed bit sequences that are input, to obtain M encoded sequences comprises:

   sequentially inputting, according to a bit order of the bit sequences and a time-domain position ascending order or a frequency-domain position ascending order of encoding blocks in an encoder, the N bit sequences into encoding sub-blocks of encoding blocks in a first encoder, and encoding the N bit sequences input into the first encoder, to obtain a first encoded sequence; and
   further comprises at least one of the following two items:

   sequentially inputting, according to the bit order of the bit sequences and a time-domain position descending order or a frequency-domain position descending order of encoding blocks in an encoder, the N bit sequences into encoding sub-blocks of encoding blocks in a second encoder, and encoding the N bit sequences input into the second encoder, to obtain a second encoded sequence; or
   inputting, according to the bit order of the bit sequences and the time-domain position ascending order or the frequency-domain position ascending order of encoding blocks in an encoder, the N bit sequences obtained after linear transformation into encoding sub-blocks of encoding blocks in a third encoder, and encoding the N bit sequences input into the third encoder after linear transformation, to obtain a third encoded sequence.

3. The method according to claim 2, wherein each encoding block comprises P encoding sub-blocks, reliability of the P encoding sub-blocks is sorted in ascending order based on a time-domain ascending order or frequency-domain ascending order, P is a positive integer, and P≥N; and the sequentially inputting, according to a bit order of the bit sequences and a time-domain ascending order of encoding blocks, the N bit sequences into encoding sub-blocks of encoding blocks in a first encoder comprises:
   inputting, according to the bit order of the bit sequences and the time-domain position ascending order or the frequency-domain position ascending order of encoding blocks in an encoder, an $i^{th}$ bit sequence of the N bit sequences into an $i^{th}$ encoding sub-block of an $i^{th}$ encoding block in the first encoder, wherein i is a positive integer, and $1\leq i\leq P$.

4. The method according to claim 2, wherein the sequentially inputting, according to the bit order of the bit sequences and a time-domain position descending order or a frequency-domain position descending order of encoding blocks, the N bit sequences into encoding sub-blocks of encoding blocks in a second encoder comprises:
inputting, according to the bit order of the bit sequences and the time-domain position descending order or the frequency-domain position descending order of encoding blocks in an encoder, a $j^{th}$ bit sequence of the N bit sequences into a $j^{th}$ encoding sub-block of a $j^{th}$ encoding block in the first encoder, wherein j is a positive integer, and $1\leq j\leq P$.

5. The method according to any one of claims 2 to 4, wherein the preprocessing N bit sequences comprises:
performing linear transformation on the N bit sequences.

6. The method according to claim 5, wherein linear transformation is performed for (M-2) times, a quantity of the third encoders is at least one, and the performing linear transformation on the N bit sequences comprises:

performing linear transformation on N bit sequences that are to be input into a $k^{th}$ third encoder, to obtain N new bit sequences, wherein k is a positive integer, and $1\leq k\leq N$; and
the sequentially inputting, according to the bit order of the bit sequences and the time-domain position ascending order of encoding blocks in an encoder, the N bit sequences obtained after linear transformation into encoding sub-blocks of encoding blocks in a third encoder comprises:
inputting an $m^{th}$ new bit sequence of the N new bit sequences into an $m^{th}$ encoding sub-block of an $m^{th}$ encoding block in the $k^{th}$ third encoder, wherein m is a positive integer, and $1\leq m\leq P$.

7. The method according to claim 6, wherein a matrix for linear transformation satisfies:

$$\begin{bmatrix} b_{j,1} & b_{j,2} & \Lambda & b_{j,N} \end{bmatrix} = \begin{bmatrix} a_1 & a_2 & \Lambda & a_N \end{bmatrix} \times \boldsymbol{F}_j \, ,$$

wherein $b_{j,1}\, b_{j,2}\, \Lambda\, b_{j,N}$ represent the N new bit sequences obtained after linear transformation is performed on N bit sequences to be input into a $j^{th}$ third encoder, $a_1\, a_2\, \Lambda\, a_N$ represent the N bit sequences to be input into the $j^{th}$ third encoder, and $\boldsymbol{F}_j$ represents the matrix for linear transformation.

8. The method according to any one of claims 3 to 7, wherein after the preprocessing N bit sequences and before the inputting, according to a position arrangement order of encoding sub-blocks of an encoding block in an encoder, N bit sequences preprocessed each time into encoding sub-blocks of encoding blocks in one of M encoders, the method further comprises:
setting an encoding sub-block in the first encoder other than the $i^{th}$ encoding sub-block to zero, setting an encoding sub-block in the second encoder other than the $j^{th}$ encoding sub-block to zero, and setting an encoding sub-block in the $k^{th}$ third encoder other than the $m^{th}$ encoding sub-block to zero.

9. The method according to claim 1, wherein the N bit sequences have a same length or different lengths, a length of a first encoding sub-block is the same as that of a second encoding sub-block, the first encoding sub-block is an encoding sub-block in one encoder into which a first bit sequence of the N bit sequences is input after the first bit sequence is preprocessed once, and the second encoding sub-block is an encoding sub-block of another encoder into which the first bit sequence is input after the first bit sequence is preprocessed for another time.

10. The method according to claim 1, wherein the encoding, in the encoders, the N preprocessed bit sequences that are input, to obtain M encoded sequences comprises:
invoking, based on a processing type of preprocessing, a coding matrix corresponding to the processing type in an encoder, and multiplying the N preprocessed bit sequences and the coding matrix, to obtain a corresponding encoded sequence.

11. A channel coding method, wherein the method comprises:

preprocessing each bit sequence in a bit sequence set in one of at least two preprocessing manners, wherein the bit sequence set comprises at least two bit sequences, each bit sequence comprises N sub-sequences, and N is a positive integer;

inputting, according to a position arrangement order of encoding sub-blocks of an encoding block in an encoder, each of N preprocessed sub-sequences into an encoding sub-block of an encoding block in one of M encoders, wherein a position of an $i^{th}$ encoding sub-block that is of a $(j+i)^{th}$ encoding block and that is corresponding to an $i^{th}$ sub-sequence of a $j^{th}$ bit sequence in the bit sequence set is represented by $Q_{i,(j+i)}$, $i<N$, i is a nonnegative integer, j and M are positive integers, and bit sequences in at least two encoders are preprocessed in different manners;

encoding a bit sequence that is in the encoding block in which $Q_{i,(j+i)}$ is located, to obtain a corresponding encoded sequence; and

respectively sending, on M parallel channels, encoded sequences obtained after each time of encoding.

12. The method according to claim 11, wherein each encoder comprises encoding blocks that are contiguous in time-domain positions or frequency-domain positions, each encoding block comprises a plurality of encoding sub-blocks, the encoding sub-blocks in the encoding block are corresponding to reliability, and in each encoding block, reliability of encoding sub-blocks is sorted in ascending order based on a time-domain ascending order or frequency-domain ascending order.

13. The method according to claim 11 or 12, wherein different bit sequences are preprocessed in different manners.

14. The method according to any one of claims 11 to 13, wherein the encoding a bit sequence that is in the encoding block in which $Q_{i,(j+i)}$ is located comprises:

in each encoder, sequentially encoding a bit sequence that is in an encoding block in which an $i^{th}$ sub-sequence of a $j^{th}$ bit sequence is located, a bit sequence that is in an encoding block in which an $i^{th}$ sub-sequence of a $(j+1)^{th}$ bit sequence is located, and a bit sequence that is in an encoding block in which an $i^{th}$ sub-sequence of a $(j+2)^{th}$ bit sequence is located.

15. The method according to any one of claims 11 to 14, wherein the inputting, according to a position arrangement order of encoding sub-blocks of an encoding block in an encoder, each of N preprocessed sub-sequences into an encoding sub-block of an encoding block in one of M encoders comprises:

sequentially inputting, according to a bit order of bits and a time-domain position ascending order or a frequency-domain position ascending order of encoding blocks in an encoder, all sub-sequences of a same bit sequence into encoding sub-blocks of encoding blocks in a first encoder; and
further comprises at least one of the following two items:

sequentially inputting, according to the bit order of the bits and a time-domain position descending order or a frequency-domain position descending order of encoding blocks in an encoder, all sub-sequences of the same bit sequence into encoding sub-blocks of encoding blocks in a second encoder; or
inputting, according to the bit order of the bits and the time-domain position ascending order or the frequency-domain position ascending order of encoding blocks in an encoder, each sub-sequence of the same bit sequence obtained after linear transformation into an encoding sub-block of an encoding block in a third encoder.

16. The method according to any one of claims 11 to 13, wherein the preprocessing manners comprise linear transformation, and when M≥3, linear transformation is performed for at least once, and a quantity of the third encoders is at least one.

17. The method according to claim 15 or 16, wherein a matrix for linear transformation satisfies:

$$\begin{bmatrix} b_{k,1} & b_{k,2} & \Lambda & b_{k,N} \end{bmatrix} = \begin{bmatrix} a_1 & a_2 & \Lambda & a_N \end{bmatrix} \times \boldsymbol{F}_k \,,$$

wherein $b_{k,1}\ b_{k,2}\ \Lambda\ b_{k,N}$ represent sub-sequences of a same bit sequence input into a $k^{th}$ third encoder after linear transformation, $a_1\ a_2\ \Lambda\ a_N$ separately represent sub-sequences of the same bit sequence that are to be input into the $k^{th}$ third encoder, $\boldsymbol{F}_k$ represents the matrix for linear transformation, N is a quantity of encoding blocks in the encoder, k and N are positive integers, and $1 \leq k \leq N$.

18. The method according to claim 11, wherein after a first preprocessed bit sequence is input into encoding sub-blocks of encoding blocks in one of the M encoders, and before the bit sequence that is in the encoding block in which $Q_{i,(j+i)}$ is located is encoded, the method further comprises:
setting an encoding sub-block, other than the position $Q_{i,(i+i)}$, in the encoder into which the first preprocessed bit sequence is currently input to zero.

19. The method according to claim 11, wherein sub-sequences of a same bit sequence have a same length or different lengths, a length of a first encoding sub-block is the same as that of a second encoding sub-block, the first encoding sub-block is an encoding sub-block in one encoder into which a first sub-sequence of the bit sequence set is input after the first sub-sequence is preprocessed once, and the second encoding sub-block is an encoding sub-block of another encoder into which the first sub-sequence is input after the first sub-sequence is preprocessed for another time.

20. The method according to claim 11 or 19, wherein the encoding a bit sequence that is in the encoding block in which $Q_{i,(j+i)}$ is located, to obtain a corresponding encoded sequence comprises:
invoking, based on a processing type of preprocessing, a coding matrix corresponding to the processing type in an encoder, and multiplying a preprocessed bit sequence set and the coding matrix, to obtain a corresponding encoded sequence.

21. A channel coding apparatus, wherein the apparatus comprises:

a processing module, configured to preprocess N bit sequences, and input, according to a position arrangement order of encoding sub-blocks of an encoding block in an encoder, N bit sequences preprocessed each time into encoding sub-blocks of encoding blocks in one of M encoders, wherein N and M are positive integers, and $M \geq 2$;
encoders, configured to encode the N preprocessed bit sequences input into the encoders, to obtain M corresponding encoded sequences; and
a transceiver module, configured to respectively send, on M parallel channels, the M encoded sequences obtained through encoding.

22. The apparatus according to claim 21, wherein each encoder comprises at least N idle encoding blocks that are contiguous in time-domain positions or frequency-domain positions, and the processing module is specifically configured to:

sequentially input, according to a bit order of the bit sequences and a time-domain position ascending order or a frequency-domain position ascending order of encoding blocks in an encoder, the N bit sequences into encoding sub-blocks of encoding blocks in a first encoder, and encode, by using the first encoder, the N bit sequences input into the first encoder, to obtain a first encoded sequence; and
further comprises at least one of the following two items:

sequentially inputting, according to the bit order of the bit sequences and a time-domain position descending order or a frequency-domain position descending order of encoding blocks in an encoder, the N bit sequences into encoding sub-blocks of encoding blocks in a second encoder, and encoding, by using the second encoder, the N bit sequences input into the second encoder, to obtain a second encoded sequence; or
inputting, according to the bit order of the bit sequences and the time-domain position ascending order or the frequency-domain position ascending order of encoding blocks in an encoder, the N bit sequences obtained after linear transformation into encoding sub-blocks of encoding blocks in a third encoder, and encoding, by using the third encoder, the N bit sequences input into the third encoder after linear transformation, to obtain a third encoded sequence.

23. The apparatus according to claim 22, wherein each encoding block comprises P encoding sub-blocks, reliability of the P encoding sub-blocks is sorted in ascending order based on a time-domain ascending order or frequency-domain ascending order, P is a positive integer, and $P \geq N$; and the processing module is specifically configured to:
input, according to the bit order of the bit sequences and the time-domain position ascending order or the frequency-domain position ascending order of encoding blocks in an encoder, an $i^{th}$ bit sequence of the N bit sequences into an $i^{th}$ encoding sub-block of an $i^{th}$ encoding block in the first encoder, wherein i is a positive integer, and $1 \leq i \leq P$.

**24.** The apparatus according to claim 22, wherein the processing module is specifically configured to:
input, according to the bit order of the bit sequences and the time-domain position descending order or the frequency-domain position descending order of encoding blocks in an encoder, a $j^{th}$ bit sequence of the N bit sequences into a $j^{th}$ encoding sub-block of a $j^{th}$ encoding block in the first encoder, wherein j is a positive integer, and $1 \leq j \leq P$.

**25.** The apparatus according to any one of claims 22 to 24, wherein the processing module is specifically configured to:
perform linear transformation on the N bit sequences.

**26.** The apparatus according to claim 25, wherein linear transformation is performed for (M-2) times, a quantity of the third encoders is at least one, and the processing module is specifically configured to:

perform linear transformation on N bit sequences that are to be input into a $k^{th}$ third encoder, to obtain N new bit sequences, wherein k is a positive integer, and $1 \leq k \leq N$; and
input an $m^{th}$ new bit sequence of the N new bit sequences into an $m^{th}$ encoding sub-block of an $m^{th}$ encoding block in the $k^{th}$ third encoder, wherein m is a positive integer, and $1 \leq m \leq P$.

**27.** The apparatus according to claim 26, wherein a matrix for linear transformation satisfies:

$$\begin{bmatrix} b_{j,1} & b_{j,2} & \Lambda & b_{j,N} \end{bmatrix} = \begin{bmatrix} a_1 & a_2 & \Lambda & a_N \end{bmatrix} \times \boldsymbol{F}_j ,$$

wherein $b_{j,1}$ $b_{j,2}$ $\Lambda$ $b_{j,N}$ represent the N new bit sequences obtained after linear transformation is performed on N bit sequences to be input into a $j^{th}$ third encoder, $a_1$ $a_2$ $\Lambda$ $a_N$ represent the N bit sequences to be input into the $j^{th}$ third encoder, and $\boldsymbol{F}_j$ represents the matrix for linear transformation.

**28.** The apparatus according to any one of claims 23 to 27, wherein after preprocessing the N bit sequences and before inputting, according to the position arrangement order of encoding sub-blocks of an encoding block in an encoder, the N bit sequences preprocessed each time into encoding sub-blocks of encoding blocks in one of the M encoders, the processing module is further configured to:
set an encoding sub-block in the first encoder other than the $i^{th}$ encoding sub-block to zero by using the first encoder, set an encoding sub-block in the second encoder other than the $j^{th}$ encoding sub-block to zero by using the second encoder, and set an encoding sub-block in the $k^{th}$ third encoder other than the $m^{th}$ encoding sub-block to zero by using the third encoder.

**29.** The apparatus according to claim 21, wherein the N bit sequences have a same length or different lengths, a length of a first encoding sub-block is the same as that of a second encoding sub-block, the first encoding sub-block is an encoding sub-block in one encoder into which a first bit sequence of the N bit sequences is input after the first bit sequence is preprocessed once, and the second encoding sub-block is an encoding sub-block of another encoder into which the first bit sequence is input after the first bit sequence is preprocessed for another time.

**30.** The apparatus according to claim 21, wherein the processing module is specifically configured to:
invoke, based on a processing type of preprocessing, a coding matrix corresponding to the processing type in an encoder, and multiply the N preprocessed bit sequences and the coding matrix, to obtain a corresponding encoded sequence.

**31.** A channel coding apparatus, wherein the apparatus comprises:

a processing module, configured to: preprocess each bit sequence in a bit sequence set in one of at least two preprocessing manners, wherein the bit sequence set comprises at least two bit sequences, each bit sequence comprises N sub-sequences, and N is a positive integer; and input, according to a position arrangement order of encoding sub-blocks of an encoding block in an encoder, each of N preprocessed sub-sequences into an encoding sub-block of an encoding block in one of M encoders, wherein a position of an $i^{th}$ encoding sub-block that is of a $(j+i)^{th}$ encoding block and that is corresponding to an $i^{th}$ sub-sequence of a $j^{th}$ bit sequence in the bit sequence set is represented by $Q_{i,(j+i)}$, $i < N$, i is a nonnegative integer, j and M are positive integers, and bit sequences in at least two encoders are preprocessed in different manners;
an encoder, configured to encode a bit sequence that is in the encoding block in which $Q_{i,(j+i)}$ is located, to obtain a corresponding encoded sequence; and

a transceiver module, configured to respectively send, on M parallel channels, encoded sequences obtained after each time of encoding.

32. The apparatus according to claim 31, wherein each encoder comprises encoding blocks that are contiguous in time-domain positions or frequency-domain positions, each encoding block comprises a plurality of encoding sub-blocks, the encoding sub-blocks in the encoding block are corresponding to reliability, and in each encoding block, reliability of encoding sub-blocks is sorted in ascending order based on a time-domain ascending order or frequency-domain ascending order.

33. The apparatus according to claim 31 or 32, wherein different bit sequences are preprocessed in different manners.

34. The apparatus according to any one of claims 31 to 33, wherein each encoder is specifically configured to:
for bit sequences in the encoder, sequentially encode a bit sequence that is in an encoding block in which an $i^{th}$ sub-sequence of a $j^{th}$ bit sequence is located, a bit sequence that is in an encoding block in which an $i^{th}$ sub-sequence of a $(j+1)^{th}$ bit sequence is located, and a bit sequence that is in an encoding block in which an $i^{th}$ sub-sequence of a $(j+2)^{th}$ bit sequence is located.

35. The apparatus according to any one of claims 31 to 34, wherein the processing module is specifically configured to:

sequentially input, according to a bit order of bits and a time-domain position ascending order or a frequency-domain position ascending order of encoding blocks in an encoder, all sub-sequences of a same bit sequence into encoding sub-blocks of encoding blocks in a first encoder; and
further comprises at least one of the following two items:

sequentially inputting, according to the bit order of the bits and the time-domain position descending order or the frequency-domain position descending order of encoding blocks in an encoder, sub-sequences of the same bit sequence into encoding sub-blocks of encoding blocks in a second encoder; or
inputting, according to the bit order of the bits and the time-domain position ascending order or the frequency-domain position ascending order of encoding blocks in an encoder, each sub-sequence of the same bit sequence obtained after linear transformation into an encoding sub-block of an encoding block in a third encoder.

36. The apparatus according to any one of claims 31 to 33, wherein the preprocessing manners comprise linear transformation, and when M≥3, linear transformation is performed for at least once, and a quantity of the third encoders is at least one.

37. The apparatus according to claim 35 or 36, wherein a matrix for linear transformation satisfies:

$$\begin{bmatrix} b_{k,1} & b_{k,2} & \Lambda & b_{k,N} \end{bmatrix} = \begin{bmatrix} a_1 & a_2 & \Lambda & a_N \end{bmatrix} \times \boldsymbol{F}_k,$$

wherein $b_{k,1}\, b_{k,2}\, \Lambda\, b_{k,N}$ represent sub-sequences of a same bit sequence input into a $k^{th}$ third encoder after linear transformation, $a_1\, a_2\, \Lambda\, a_N$ separately represent sub-sequences of the same bit sequence that are to be input into the $k^{th}$ third encoder, $\boldsymbol{F}_k$ represents the matrix for linear transformation, N is a quantity of encoding blocks in the encoder, k and N are positive integers, and $1 \leq k \leq N$.

38. The apparatus according to claim 31, wherein after the processing module inputs a first preprocessed bit sequence into encoding sub-blocks of encoding blocks in one of the M encoders, and before the processing module encodes the bit sequence that is in the encoding block in which $Q_{i,(j+i)}$ is located, the encoder is further configured to:
set an encoding sub-block, other than the position $Q_{i,(i+i)}$, in the encoder into which the first preprocessed bit sequence is currently input to zero.

39. The apparatus according to claim 31, wherein sub-sequences of a same bit sequence have a same length or different lengths, a length of a first encoding sub-block is the same as that of a second encoding sub-block, the first encoding sub-block is an encoding sub-block in one encoder into which a first sub-sequence of the bit sequence set is input after the first sub-sequence is preprocessed once, and the second encoding sub-block is an encoding sub-block of another encoder into which the first sub-sequence is input after the first sub-sequence is preprocessed for another time.

40. The apparatus according to claim 31 or 39, wherein the encoder is specifically configured to:
    invoke, based on a processing type of preprocessing, a coding matrix corresponding to the processing type in the encoder, and multiply a preprocessed bit sequence set and the coding matrix, to obtain a corresponding encoded sequence.

41. A channel coding apparatus, wherein the channel coding apparatus comprises:

    at least one processor, a memory, an encoder, and a transceiver, wherein
    the memory is configured to store program code, and the processor is configured to invoke the program code stored in the memory to perform the method according to any one of claims 1 to 10, or perform the method according to any one of claims 11 to 20.

42. A chip system, comprising at least one processor, a memory, an encoder, and a communications unit, wherein the memory, the encoder, the communications unit, and the at least one processor are interconnected by using a line, the at least one memory stores an instruction, and the processor executes the instruction, to perform an operation of the channel coding apparatus in the method according to any one of claims 1 to 10, or perform an operation of the channel coding apparatus in the method according to any one of claims 11 to 20.

43. A computer readable storage medium, comprising an instruction, wherein when the instruction runs on a computer, the computer is caused to perform the method according to any one of claims 1 to 10 or the method according to any one of claims 11 to 20.

Preprocess N bit sequences 101

Input, according to a position arrangement order of encoding sub-blocks of an encoding block in an encoder, N bit sequences preprocessed each time into encoding blocks in one of M encoders 102

Obtain M corresponding encoded sequences after encoding, in the encoders, the N preprocessed bit sequences that are input 103

Respectively send the M obtained encoded sequences on M parallel channels through resource mapping 104

FIG. 1

Reliability from low to high

| #N–1 | #N–2 | ... | #2 | #1 | #0 |

Time-domain ascending order

Encoding block

Encoding sub-block

(a)

Reliability from low to high

Frequency-domain ascending order

| #N–1 |
| #N–2 |
| ... |
| #2 |
| #1 |
| 0 |

Encoding block

Encoding sub-block

(b)

FIG. 2-1

| | | | |
|---|---|---|---|
| $\cdots$ $a_{1,0}$ | $\cdots$ $a_{1,1}$ | $\cdots$ $a_{1,N-2}$ $\cdots$ | $a_{1,N-1}$ $\cdots$ | Mapping from an X Galois field onto binary | Encoding |
| $\cdots$ $b_{2,0}$ | $\cdots$ $b_{2,1}$ | $\cdots$ $b_{2,N-2}$ $\cdots$ | $b_{2,N-1}$ $\cdots$ | Mapping from an X Galois field onto binary | Encoding |
| $\cdots$ $b_{3,0}$ | $\cdots$ $b_{3,1}$ | $\cdots$ $b_{3,N-2}$ $\cdots$ | $b_{3,N-1}$ $\cdots$ | Mapping from an X Galois field onto binary | Encoding |

$\cdots$

| | | | |
|---|---|---|---|
| $\cdots$ $b_{M-1,0}$ | $\cdots$ $b_{M-1,1}$ | $\cdots$ $b_{M-1,N-2}$ $\cdots$ | $b_{M-1,N-1}$ $\cdots$ | Mapping from an X Galois field onto binary | Encoding |
| $\cdots$ $a_{M,N-1}$ | $\cdots$ $a_{M,N-2}$ | $\cdots$ $a_{M,1}$ $\cdots$ | $a_{M,0}$ $\cdots$ | Mapping from an X Galois field onto binary | Encoding |

Encoding sub-block

Encoder

Encoding block

FIG. 2-2

FIG. 3

| 0 | 0 | $a_0$ | | 0 | $a_1$ | $b_0$ | | $a_2$ | $b_1$ | $c_0$ | | $b_2$ | $c_1$ | $d_0$ | | $c_2$ | $d_1$ | $e_0$ | | $d_2$ | $e_1$ | $f_0$ | → Encoding |

| 0 | 0 | $a_2$ | | 0 | $a_1$ | $b_2$ | | $a_0$ | $b_1$ | $c_2$ | | $b_0$ | $c_1$ | $d_2$ | | $c_0$ | $d_1$ | $e_2$ | | $d_0$ | $e_1$ | $f_2$ | → Encoding |

Encoder

Encoding block

Encoding sub-block

← rN → ← (1–2r)N → ← rN →

Encoding sub-block

FIG. 4

| 0 | 0 | 0 | 0 | $a_0$ | | 0 | 0 | 0 | $a_1$ | $b_0$ | | 0 | 0 | $a_2$ | $b_1$ | $c_0$ | | 0 | $a_3$ | $b_2$ | $c_1$ | $d_0$ | | $a_4$ | $b_3$ | $c_2$ | $d_1$ | $e_0$ | | $b_4$ | $c_3$ | $d_2$ | $e_1$ | $f_0$ | → Encoding |

| 0 | 0 | 0 | 0 | $a_4$ | | 0 | 0 | 0 | $a_3$ | $b_4$ | | 0 | 0 | $a_2$ | $b_3$ | $c_4$ | | 0 | $a_1$ | $b_2$ | $c_3$ | $d_4$ | | $a_0$ | $b_1$ | $c_2$ | $d_3$ | $e_4$ | | $b_0$ | $c_1$ | $d_2$ | $e_3$ | $f_4$ | → Encoding |

Encoding sub-block

Encoding block

Encoder

| ← $r_1N$ → | ← $(r_2-r_1)N$ → | ← $(1-2r_2)N$ → | ← $(r2-r_1)N$ → | ← $r_1N$ → |
| | | | | |

Encoding sub-block

FIG. 5

Preprocess a first data stream and a second data stream separately ⌐ 201

Separately input, according to a position arrangement order of encoding sub-blocks of an encoding block in an encoder, bit sequences of a first data stream preprocessed each time and bit sequences of a second data stream preprocessed each time into different encoding blocks in one of M encoders ⌐ 202

In each encoder, encode a bit sequence that is in an encoding block in which a $k^{th}$ bit sequence of the first data stream is located, to obtain an encoded sequence ⌐ 203

Respectively send obtained encoded sequences on M parallel channels through resource mapping ⌐ 204

FIG. 6

Encoding block

Encoding sub-block

Encoding sub-block x

Encoding sub-block y

| $a_0$ | $b_0$ | $c_0$ | $d_0$ | $e_0$ | 0 | 0 |
|---|---|---|---|---|---|---|
| 0 | $a_1$ | $b_1$ | $c_1$ | $d_1$ | $e_1$ | 0 |
| 0 | 0 | $a_2$ | $b_2$ | $c_2$ | $d_2$ | $e_2$ |
| 0 | 0 | 0 | $a_3$ | $b_3$ | 0 | 0 |
| 0 | 0 | 0 | 0 | $a_4$ | $b_4$ | 0 |

Reliability from low to high

Channel #1

FIG. 7

FIG. 8

```
┌─────────────────────────────────────────────────────────────┐    ╭─ 301
│  Preprocess each bit sequence in a bit sequence set in one of at least two  │   ╱
│                      preprocessing manners                    │
└─────────────────────────────────────────────────────────────┘
                              │
                              ▼
┌─────────────────────────────────────────────────────────────┐    ╭─ 302
│  Input, according to a position arrangement order of encoding sub-blocks of  │   ╱
│  an encoding block in an encoder, each of N preprocessed sub-sequences into  │
│      an encoding sub-block of an encoding block in one of M encoders   │
└─────────────────────────────────────────────────────────────┘
                              │
                              ▼
┌─────────────────────────────────────────────────────────────┐    ╭─ 303
│  Encode a bit sequence that is in an encoding block in which $Q_{i,(j+i)}$ is located,  │   ╱
│              to obtain a corresponding encoded sequence        │
└─────────────────────────────────────────────────────────────┘
                              │
                              ▼
┌─────────────────────────────────────────────────────────────┐    ╭─ 304
│  Respectively send, on M parallel channels through resource mapping,  │   ╱
│          encoded sequences obtained after each time of encoding    │
└─────────────────────────────────────────────────────────────┘
```

FIG. 9

Bit sequence

```
            │
            ▼
┌───────────────────────────────────────────────────┐
│  ┌──────────────┐          ┌──────────────┐         │
│  │ Processing   │──────────│   Encoder    │        C│
│  │  module      │●        ●│              │        h│
│  └──────────────┘          └──────────────┘        a│
│         │                         │                n│
│         │     ┌──────────────┐    │                n│
│         └────●│ Transceiver  │●───┘                e│
│              │   module     │                     l│
│              └──────────────┘                      │
└───────────────────────────────────────────────────┘
```
Channel encoding apparatus

Encoded sequence

FIG. 10

Channel coding apparatus

Processor

Memory

Encoder

Bus

Transceiver

FIG. 11

Channel coding apparatus

Processor

Encoder

Memory

Bus

Transceiver

FIG. 12

# INTERNATIONAL SEARCH REPORT

| | International application No. |
| --- | --- |
| | PCT/CN2017/115569 |

**A. CLASSIFICATION OF SUBJECT MATTER**

H04L 1/00 (2006.01) i

According to International Patent Classification (IPC) or to both national classification and IPC

**B. FIELDS SEARCHED**

Minimum documentation searched (classification system followed by classification symbols)

H04L; H04W

Documentation searched other than minimum documentation to the extent that such documents are included in the fields searched

Electronic data base consulted during the international search (name of data base and, where practicable, search terms used)

CNPAT; WPI; EPODOC; CNKI; IEEE: 编码, 编码器, 编码块, 序列, 比特, 输入, 位置, 顺序, 排序, 预处理, 信道, 并行信道, 容量, 时域, 频域, encod+, sequence, bit, input, location, order, preprocess+, channel, parallel channel, capacity, time domain, frequency domain

**C. DOCUMENTS CONSIDERED TO BE RELEVANT**

| Category* | Citation of document, with indication, where appropriate, of the relevant passages | Relevant to claim No. |
| --- | --- | --- |
| A | CN 103516465 A (HUAWEI TECHNOLOGIES CO., LTD.) 15 January 2014 (15.01.2014), description, paragraphs [0061], [0062], [0073], and [0185] | 1-43 |
| A | CN 101667884 A (ZTE CORPORATION) 10 March 2010 (10.03.2010), entire document | 1-43 |
| A | CN 105450329 A (HUAWEI TECHNOLOGIES CO., LTD.) 30 March 2016 (30.03.2016), entire document | 1-43 |
| A | US 2015110016 A1 (LG ELECTRONICS INC.) 23 April 2015 (23.04.2015), entire document | 1-43 |

☐ Further documents are listed in the continuation of Box C.　　☒ See patent family annex.

| | |
| --- | --- |
| *　　Special categories of cited documents: | "T"　later document published after the international filing date or priority date and not in conflict with the application but cited to understand the principle or theory underlying the invention |
| "A"　document defining the general state of the art which is not considered to be of particular relevance | |
| "E"　earlier application or patent but published on or after the international filing date | "X"　document of particular relevance; the claimed invention cannot be considered novel or cannot be considered to involve an inventive step when the document is taken alone |
| "L"　document which may throw doubts on priority claim(s) or which is cited to establish the publication date of another citation or other special reason (as specified) | "Y"　document of particular relevance; the claimed invention cannot be considered to involve an inventive step when the document is combined with one or more other such documents, such combination being obvious to a person skilled in the art |
| "O"　document referring to an oral disclosure, use, exhibition or other means | |
| "P"　document published prior to the international filing date but later than the priority date claimed | "&"document member of the same patent family |

| Date of the actual completion of the international search | Date of mailing of the international search report |
| --- | --- |
| 08 February 2018 | 24 February 2018 |

| Name and mailing address of the ISA State Intellectual Property Office of the P. R. China No. 6, Xitucheng Road, Jimenqiao Haidian District, Beijing 100088, China Facsimile No. (86-10) 62019451 | Authorized officer　　　　LIN, Guirong Telephone No. (86-10) 53961573 |

Form PCT/ISA /210 (second sheet) (July 2009)

## INTERNATIONAL SEARCH REPORT
Information on patent family members

| | International application No. |
|---|---|
| | PCT/CN2017/115569 |

| Patent Documents referred in the Report | Publication Date | Patent Family | Publication Date |
|---|---|---|---|
| CN 103516465 A | 15 January 2014 | None | |
| CN 101667884 A | 10 March 2010 | None | |
| CN 105450329 A | 30 March 2016 | WO 2015180662 A1 | 03 December 2015 |
| US 2015110016 A1 | 23 April 2015 | CN 104054292 A | 17 September 2014 |
| | | WO 2013105836 A1 | 18 July 2013 |

Form PCT/ISA /210 (patent family annex) (July 2009)

**REFERENCES CITED IN THE DESCRIPTION**

**Patent documents cited in the description**

- CN 201611204798